(19) **Europäisches Patentamt European Patent Office Office européen des brevets**

(11) **EP 4 592 704 A1**

(12) **EUROPEAN PATENT APPLICATION**

(43) Date of publication:
**30.07.2025 Bulletin 2025/31**

(21) Application number: **24188787.6**

(22) Date of filing: **16.07.2024**

(51) International Patent Classification (IPC):
**G01S 7/481** (2006.01)   **H01S 5/042** (2006.01)
**H01S 5/42** (2006.01)

(52) Cooperative Patent Classification (CPC):
**G01S 7/4814; H01S 5/0428; H01S 5/423**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.01.2024 JP 2024009050**

(71) Applicant: **FUJIFILM Business Innovation Corp.**
**Minato-ku**
**Tokyo (JP)**

(72) Inventors:
• **KONDO, Takashi**
  **Ebina-shi, Kanagawa (JP)**
• **HAYAKAWA, Junichiro**
  **Ebina-shi, Kanagawa (JP)**
• **NAKAMURA, Shigetoshi**
  **Ebina-shi, Kanagawa (JP)**

(74) Representative: **Kurig, Thomas**
**Becker Kurig & Partner**
**Patentanwälte mbB**
**Bavariastraße 7**
**80336 München (DE)**

(54) **LIGHT EMITTING DEVICE AND MEASUREMENT APPARATUS**

(57)   A light emitting device includes a substrate, a light emitting unit that is provided on the substrate and has plural light emitting sections, a first switching unit that is provided on the substrate and switches a first light emitting section of the light emitting unit between a light emitting state and a non-light emitting state, and a second switching unit that is provided on the substrate on an opposite side of the first switching unit with the light emitting unit interposed between the first switching unit and the second switching unit, switches a second light emitting section different from the first light emitting section of the light emitting unit, between the light emitting state and the non-light emitting state.

EP 4 592 704 A1

**Description**

BACKGROUND OF THE INVENTION

(i) Field of the Invention

The present invention relates to a light emitting device and a measurement apparatus.

(ii) Description of Related Art

JP2023-42123A discloses a light emitting device including a substrate, a light emitting element unit that is provided on the substrate and has 12 areas each having a light emitting element, and a transfer circuit that supplies a transfer signal for changing a light emitting state and a non-light emitting state to the light emitting element unit.

SUMMARY OF THE INVENTION

In a light emitting device or the like having a plurality of light emitting sections on a substrate, in a case where a switching unit that switches each of the light emitting sections between a light emitting state and a non-light emitting state is provided at one place on the substrate, there may be many portions where a distance from the switching unit to the light emitting section is long.

An object of the present invention is to shorten a distance from a switching unit to each of a plurality of light emitting sections as compared with a case where the switching unit that switches the plurality of light emitting sections between a light emitting state and a non-light emitting state is provided at one place on a substrate.

According to a first aspect of the present disclosure, there is provided a light emitting device including a substrate, a light emitting unit that is provided on the substrate and has a plurality of light emitting sections, a first switching unit that is provided on the substrate and switches a first light emitting section of the light emitting unit between a light emitting state and a non-light emitting state, and a second switching unit that is provided on the substrate on an opposite side of the first switching unit with the light emitting unit interposed between the first switching unit and the second switching unit, switches a second light emitting section different from the first light emitting section of the light emitting unit, between the light emitting state and the non-light emitting state.

According to a second aspect of the present disclosure, in light emitting device according to the first aspect, the first switching unit and the second switching unit may be connected by a wiring, and the first light emitting section and the second light emitting section of the light emitting unit may be sequentially switched to the light emitting state and the non-light emitting state by a signal transmitted through the wiring.

According to a third aspect of the present disclosure, in the light emitting device according to the first aspect, the substrate may have a rectangular shape including two first sides facing each other and two second sides that connect the first sides and face each other, the first switching unit may be provided along one of the first sides, and the second switching unit may be provided along the other of the first sides, and the wiring is provided along one of the second sides.

According to a fourth aspect of the present disclosure, the light emitting device according to the third aspect may further include a terminal that is provided along the other of the second sides of the substrate and receives a supply of power to the light emitting unit.

According to a fifth aspect of the present disclosure, in the light emitting device according to any one of the second to fourth aspects, an electrical resistance between the first switching unit and the first light emitting section, and an electrical resistance between the second switching unit and the second light emitting section may be larger than an electrical resistance of the wiring.

According to a sixth aspect of the present disclosure, in the light emitting device according to any one of the first to fifth aspects, in the light emitting unit, the plurality of light emitting sections may be two-dimensionally arranged by being arranged in a first direction and a second direction intersecting the first direction, the number of the light emitting sections arranged in the first direction may be larger than the number of the light emitting sections arranged in the second direction, and the first switching unit and the second switching unit may be disposed along the first direction.

According to a seventh aspect of the present invention, in the light emitting device according to the sixth aspect, first light emitting sections may be arranged in the first direction, second light emitting sections may be arranged in the second direction with respect to the respective first light emitting sections, a region irradiated with light by one light emitting section in the first light emitting section may overlap a region irradiated with light by another light emitting section that is arranged in the second direction with respect to the one light emitting section in the second light emitting section, and the first switching unit and the second switching unit may select any of the one light emitting section or the other light emitting section and switch the selected light emitting section to the light emitting state.

According to an eighth aspect of the present disclosure, in the light emitting device according to the seventh aspect, the first light emitting section and the second light emitting section may have different intensities of emitted light.

According to a ninth aspect of the present disclosure, the light emitting device according to the seventh aspect may further include an optical system that guides light emitted from each of the first light emitting section and the second light emitting section such that there is a portion in which the region irradiated with light by the one light emitting section of the first light emitting section overlaps the region irradiated with light by the other light emitting section of the second light emitting section, in which, in the optical system, a diffusion degree of the light emitted from each of the light emitting sections in the first direction may be larger than a diffusion degree of the light in the second direction.

According to a tenth aspect of the present disclosure, the light emitting device according to the seventh aspect may further include an optical system that guides light emitted from each of the first light emitting section and the second light emitting section such that there is a portion in which the region irradiated with light by the one light emitting section of the first light emitting section overlaps the region irradiated with light by the other light emitting section of the second light emitting section, in which the optical system may not optically act in the second direction, but optically act in the first direction.

According to an eleventh aspect of the present disclosure, there is provided a measurement apparatus including the light emitting device in any one of the first to tenth aspects, and an acquisition unit that receives reflected light from a measurement target irradiated with light emitted from the light emitting device, and acquires information regarding the measurement target.

According to a twelfth aspect of the present disclosure, there is provided a light emitting device including a substrate, a light emitting unit that is provided on the substrate and has a plurality of light emitting sections, in which the plurality of light emitting sections are two-dimensionally arranged by being arranged in a first direction and a second direction intersecting the first direction, and the number of the light emitting sections arranged in the first direction is larger than the number of the light emitting sections arranged in the second direction, and an optical system that guides light emitted from the light emitting section, in which, in the optical system, a diffusion degree of the light emitted from each of the light emitting sections in the first direction is larger than a diffusion degree of the light emitted in the second direction.

According to a thirteenth aspect of the present disclosure, there is provided a light emitting device including a substrate, a light emitting unit that is provided on the substrate and has a plurality of light emitting sections, in which the plurality of light emitting sections are two-dimensionally arranged by being arranged in a first direction and a second direction intersecting the first direction, and the number of the light emitting sections arranged in the first direction is larger than the number of the light emitting sections arranged in the second direction, and an optical system that guides light emitted from the light emitting section, in which the optical system does not optically act in the second direction, but optically acts in the first direction.

According to a fourteenth aspect of the present disclosure, there is provided a light emitting device including a substrate, a light emitting unit that is provided on the substrate and has a plurality of light emitting sections, in which the plurality of light emitting sections are two-dimensionally arranged by being arranged in a first direction and a second direction intersecting the first direction, and the number of the light emitting sections arranged in the first direction is larger than the number of the light emitting sections arranged in the second direction, and an optical system that guides light emitted from the light emitting section, in which the optical system acts such that a region irradiated with light from one light emitting section among the plurality of light emitting sections overlaps a region irradiated with light from another light emitting section arranged in the second direction with respect to the one light emitting section.

According to the first and eleventh aspects of the present invention, it is possible to shorten a distance from a switching unit to each of a plurality of light emitting sections as compared with a case where the switching unit that switches the plurality of light emitting sections between a light emitting state and a non-light emitting state is provided at one place on a substrate.

According to the second aspect of the present invention, it is possible to suppress an occurrence of a situation in which the light emitting section connected to the first switching unit and the light emitting section connected to the second switching unit are unintentionally lit at the same time, as compared with a case where the first switching unit and the second switching unit are connected.

According to the third aspect of the present invention, it is possible to suppress complication of the wiring as compared with a case in which the wiring is not provided along the second side but is provided on a rear surface or the like.

According to the fourth aspect of the present invention, it is possible to suppress an increase in size of the device in a direction along the first side as compared with a case in which the terminal is not provided along the other of the second sides.

According to the fifth aspect of the present invention, it is possible to shorten a distance between the first switching unit and the second switching unit having a large electrical resistance, and the light emitting section as compared with a case where the switching unit is provided at one place on the substrate.

According to the sixth aspect of the present invention, it is possible to shorten a distance between each of the light emitting sections, and the first switching unit or the second switching unit as compared with a case where the first switching unit and the second switching unit are disposed along the second direction.

According to the seventh aspect and the fourteenth aspect of the present invention, it is possible to cause one light emitting section and the other light emitting section to irradiate the same region with light.

According to the eighth aspect of the present invention, it is possible to perform irradiation by selecting an intensity of light for each region arranged in the first direction.

According to the ninth aspect and the twelfth aspect of the present invention, it is possible to irradiate a similar region in the second direction with light as compared with a case where the diffusion degree in the first direction is identical to the diffusion degree in the second direction in the optical system.

According to the tenth aspect and the thirteenth aspect of the present invention, the light is stable as compared with a case where the optical system optically acts in the second direction.

BRIEF DESCRIPTION OF THE DRAWINGS

Exemplary embodiment(s) of the present invention will be described in detail based on the following figures, wherein:

Fig. 1 is a diagram showing an example of a measurement apparatus to which the present exemplary embodiment is applied;
Fig. 2 is a diagram showing a light source device to which the present exemplary embodiment is applied, and is a diagram showing an equivalent circuit of the light source device;
Fig. 3 is a diagram showing a planar shape of a light emitting chip to which the present exemplary embodiment is applied, and is a plan view of the light emitting chip as viewed from a side on which light is emitted;
Figs. 4A and 4B are enlarged views of the light emitting chip shown in Fig. 3;
Fig. 5 is an example of a cross-sectional view of the light emitting chip and is a cross-sectional view taken along line V-V of Fig. 4A;
Fig. 6 is a timing chart showing an example of operations of the light source device and the light emitting chip;
Fig. 7 is a diagram showing a planar shape of a light emitting chip to which a second exemplary embodiment is applied, and is a plan view of the light emitting chip as viewed from a side on which light is emitted;
Fig. 8 is a diagram showing a relationship between the light emitting chip and an optical system according to the present exemplary embodiment;
Fig. 9 is a diagram showing the relationship between the light emitting chip and the optical system according to the present exemplary embodiment;
Fig. 10 is a diagram showing an example of an illuminance distribution of one light emitting section belonging to a light emitting section group and an illuminance distribution of another light emitting section belonging to the light emitting section group; and
Fig. 11 is a diagram showing an example of an irradiation surface irradiated with light emitted from a light emitting section of a light emitting unit.

DETAILED DESCRIPTION OF THE INVENTION

Hereinafter, exemplary embodiments of the present invention will be described in detail with reference to the accompanying drawings.

Here, a case where the light source device 1 including a light emitting chip 10 which is an example of a light emitting component is applied to a measurement apparatus 100 that measures a three-dimensional shape (referred to as a 3D shape below) of a target object being a measurement target, as an example, will be described.

[First Exemplary Embodiment]

(Measurement Apparatus 100)

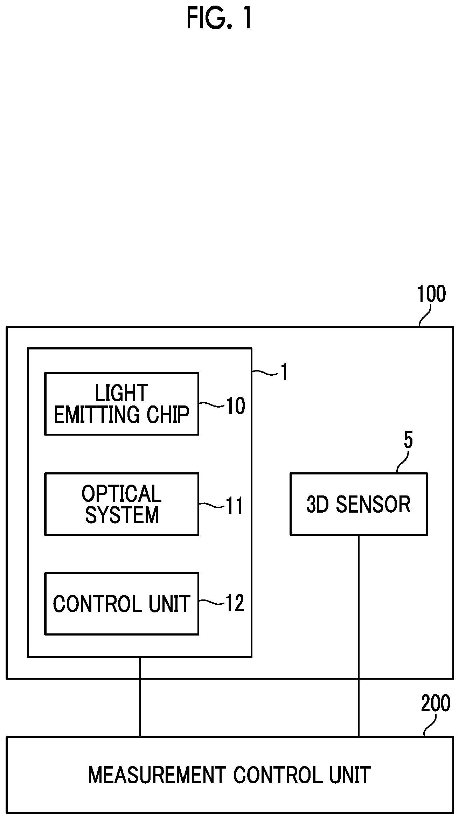

Fig. 1 is a diagram showing an example of a measurement apparatus 100 according to the present exemplary embodiment.

The measurement apparatus 100 according to the present exemplary embodiment measures a three-dimensional shape of a target object. The three-dimensional shape will be referred to as a 3D shape below. The measurement apparatus 100 is an apparatus that measures a 3D shape on the basis of a so-called time-of-flight (ToF) method on the basis of the flight time of light. The measurement apparatus 100 includes a light source device 1 as an example of a light emitting device including a light emitting chip 10 and a control unit 12 and a three-dimensional sensor 5. The three-dimensional sensor 5 will be referred to as a 3D sensor 5 below. In the ToF method, a time from the timing at which light is emitted from the light source device 1 to the timing at which light is reflected by the target object and received by the 3D sensor 5 is measured. Then, a distance to the target object is calculated from the time acquired from the 3D sensor 5, and the 3D shape of the target object is specified. In addition, measuring a 3D shape may be referred to as three-dimensional measurement, 3D measurement, or 3D sensing.

The light source device 1 emits light toward the target object. The 3D sensor 5 acquires reflected light which has been reflected by the target object and returned. The 3D sensor 5 outputs distance information regarding the distance to the target object, which is measured by the ToF method and is based on the time from the emission to the reception of the reflected light. The measurement apparatus 100 may include a measurement control unit 200. The measurement control unit 200 is configured as a computer including a central processing unit (CPU), a read only memory (ROM), a random access memory (RAM), and the like, and specifies a 3D shape of the target object based on the distance information acquired from the 3D sensor 5.

In addition, the measurement apparatus 100 can be applied to recognize the target object from the specified 3D shape. For example, the measurement apparatus 100 is mounted on a portable information processing apparatus or the like and is used for recognizing a face of a user who intends to access the apparatus. That is, the measurement apparatus acquires the 3D shape of the face of the accessing user, and identifies whether or not the access is permitted. Only in a case where it is recognized that the user is permitted to access the information processing apparatus, using a portable information processing apparatus being the portable information processing apparatus is permitted.

Further, the measurement apparatus 100 can be applied to a case where the 3D shape of the target object is continuously measured, such as augmented reality (AR).

(Light Source Device 1)

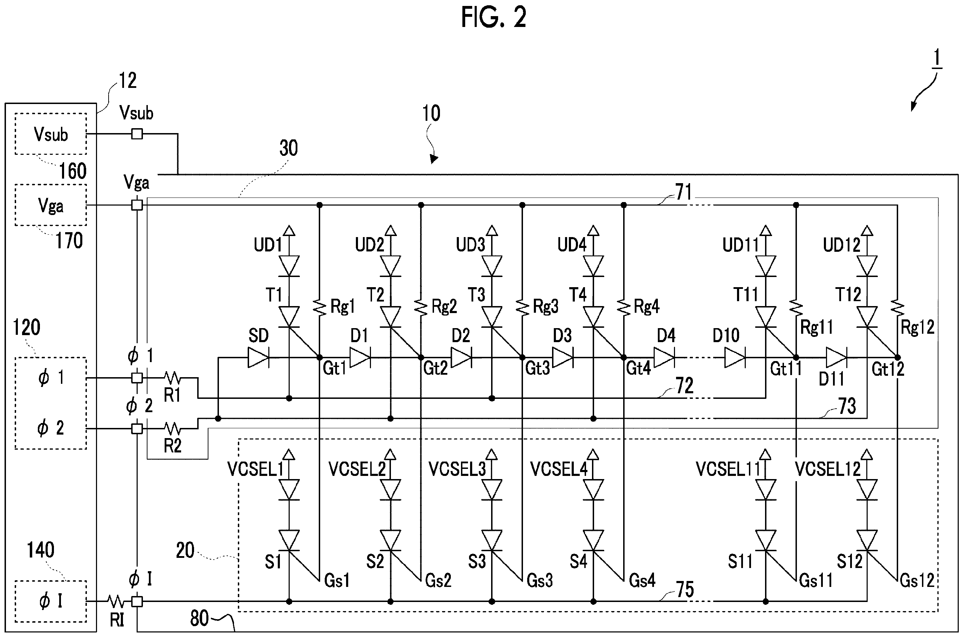

Fig. 2 is a diagram showing the light source device 1 to which the present exemplary embodiment is applied, and is a diagram showing an equivalent circuit of the light source device 1. In the light source device 1 shown in Fig. 2, the positions of a φ1 terminal, a φ2 terminal, a Vga terminal, and a φl terminal are not constantly accurate.

The light source device 1 includes the light emitting chip 10 that emits light, an optical system 11 (see Fig. 1) that expands an irradiation range of light emitted from the light emitting chip 10, and the control unit 12 that controls an operation of the light emitting chip 10.

In the present exemplary embodiment, the light source device 1 or the light emitting chip 10 is an example of a light emitting device.

(Control Unit 12)

The control unit 12 includes a transfer signal generation unit 120, a lighting signal generation unit 140, a reference potential supply unit 160, and a power source potential supply unit 170.

The transfer signal generation unit 120 generates transfer signals φl and φ2 for sequentially transferring an ON state to a plurality of transfer thyristors T, which will be described later. The lighting signal generation unit 140 generates a lighting signal φl for supplying a current for lighting a VCSEL, which will be described below. The reference potential supply unit 160 supplies a reference potential Vsub. The power source potential supply unit 170 supplies a power source potential Vga.

(Light Emitting Chip 10)

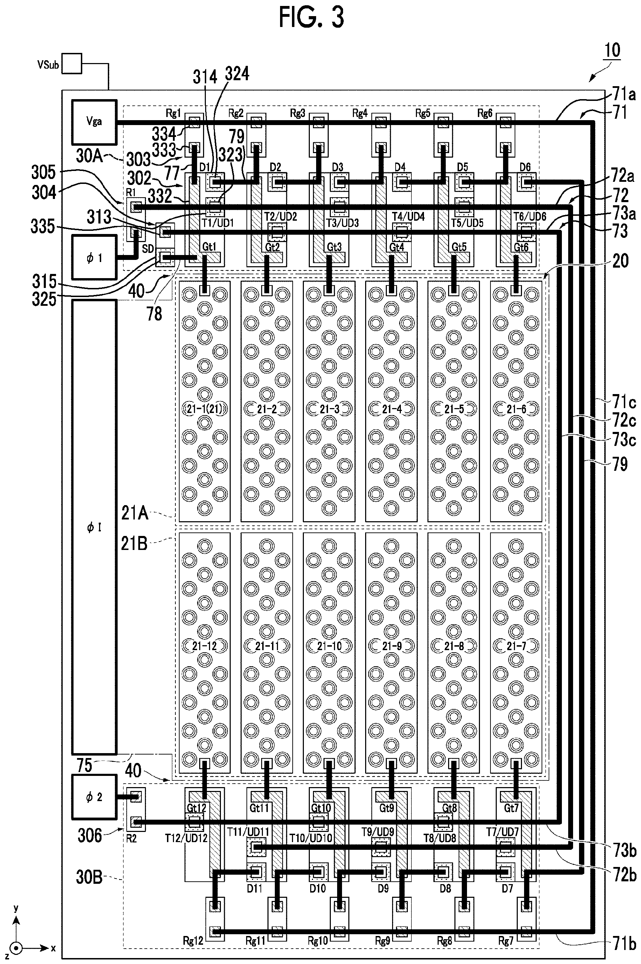

Fig. 3 is a diagram showing a planar shape of the light emitting chip 10 to which the present exemplary embodiment is applied, and is a plan view of the light emitting chip 10 as viewed from a side on which light is emitted. In Fig. 3, a rightward direction of the paper plane is defined as a +x direction, an upward direction of the paper plane is defined as a +y direction, and a front side of the paper plane is defined as a +z direction. Opposite directions of the directions are defined as -x, -y, and -z directions, respectively.

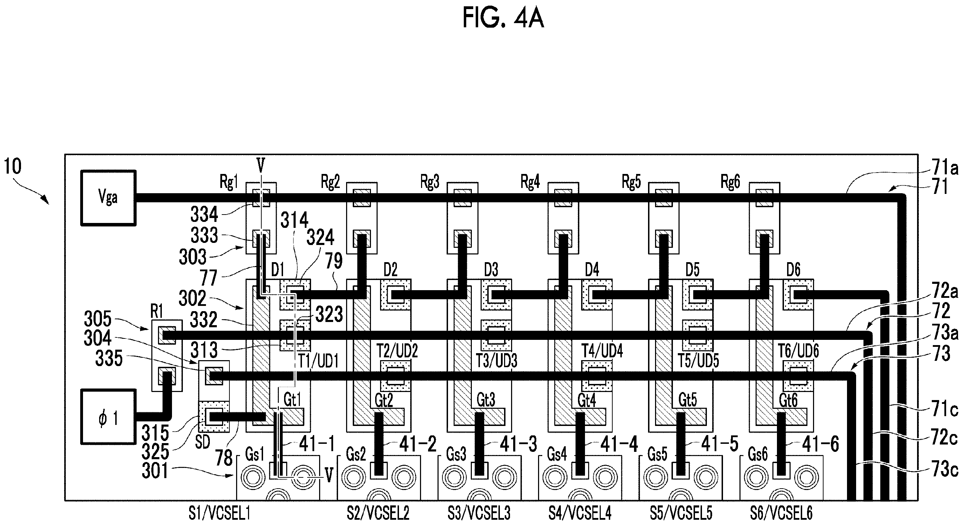

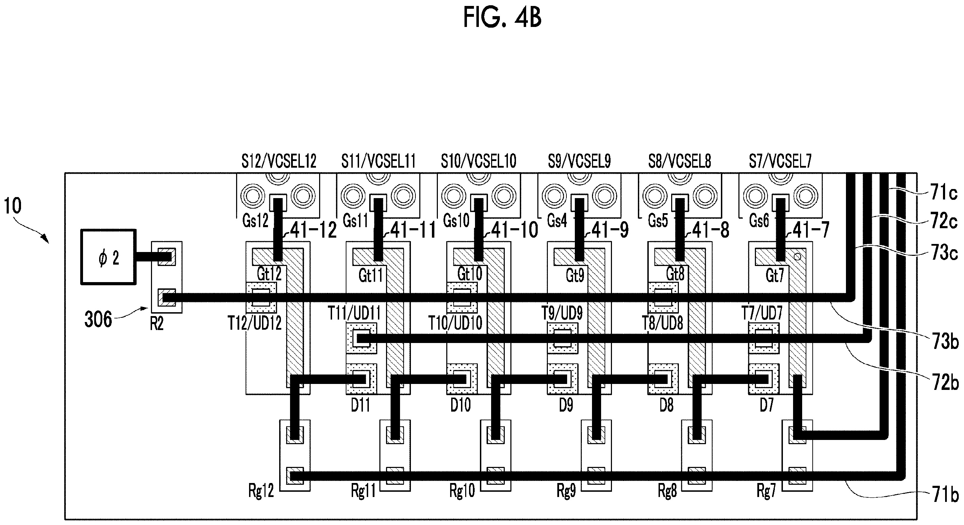

Figs. 4A and 4B are enlarged views of the light emitting chip 10 shown in Fig. 3. Fig. 4A is an enlarged view of the light emitting chip 10 of Fig. 3 on the +y direction side, and Fig. 4B is an enlarged view of the light emitting chip 10 of Fig. 3 on the -y direction side.

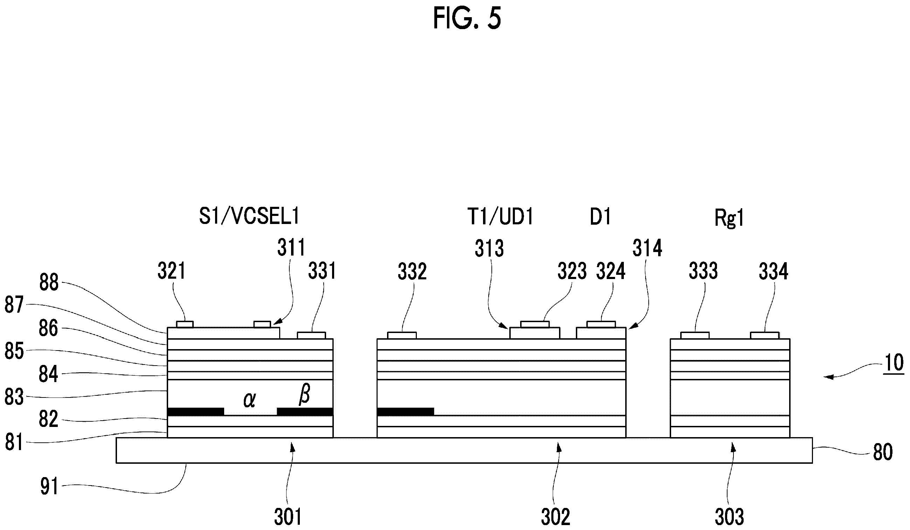

Fig. 5 is an example of a cross-sectional view of the light emitting chip 10 and is a cross-sectional view taken along line V-V of Fig. 4A.

The light emitting chip 10 includes a light emitting unit 20 and a transfer unit 30 (see Fig. 2) on a substrate 80. In addition, the light emitting chip 10 includes a connection portion 40 that connects the light emitting unit 20 and the transfer unit 30 on the substrate 80.

Further, the light emitting chip 10 includes a φ1 terminal, a φ2 terminal, a Vga terminal, a φl terminal, and a Vsub terminal.

In the present exemplary embodiment, the substrate 80 has a planar shape viewed from the +z direction side, which is a rectangular shape having a first side extending in the x direction and a second side extending in the y direction in a planar shape.

The light emitting unit 20 includes a vertical cavity surface emitting laser (VCSEL). The vertical cavity surface emitting laser VCSEL will be referred to as a VCSEL below.

The light emitting unit 20 has a plurality of light emitting sections 21 each of which includes at least one VCSEL. In the present exemplary embodiment, the light emitting unit 20 has a total of 12 light emitting sections 21, that is, 6 light emitting sections 21 in the x direction and 2 light emitting sections 21 in the y direction. Here, in a case where the light emitting sections 21 are distinguished from each other, the 12 light emitting sections 21 are referred to as the light emitting sections 21-1 to 21-12. In addition, VCSELs in the respective light emitting sections 21-1 to 21-12 may be referred to as VCSEL1 to VCSEL12, respectively.

In the light emitting unit 20 in the present exemplary embodiment, the areas of the light emitting sections 21-1 to 21-12 as viewed from the +z direction side are equal to each other. In a case where the same amount of power is supplied to the light emitting sections 21-1 to 21-12, the intensity of light emitted from the light emitting sections 21-1 to 21-12 are equal to each other in the light emitting unit 20.

The six light emitting sections 21-1 to 21-6 are disposed to be arranged in this order from the -x direction side to the +x direction side in the light emitting unit 20. Such light emitting sections 21-1 to 21-6 may be collectively referred to as a light emitting section group 21A below. In the present exemplary embodiment, the light emitting sections 21-1 to 21-6 are examples of first light emitting sections, and the light emitting section group 21A is an example of a first light emitting section group.

In addition, the six light emitting sections 21-7 to 21-12 are disposed to be arranged in this order from the +x direction side to the -x direction side in the light emitting unit 20. Such light emitting sections 21-7 to 21-12 may be collectively referred to as a light emitting section group 21B below. In the present exemplary embodiment, the light emitting sections 21-7 to 21-12 are examples of second light emitting sections, and the light emitting section group 21B is an example of a second light emitting section group.

The light emitting section group 21A and the light emitting section group 21B are disposed to be arranged in this order from the +y direction side to the -y direction side. It should be noted that the light emitting sections 21-1, 21-2, 21-3, 21-4, 21-5, and 21-6 belonging to the light emitting section group 21A are disposed to be arranged in the +y direction with respect to the light emitting sections 21-12, 21-11, 21-10, 21-9, 21-8, and 21-7 belonging to the light emitting section group 21B, respectively.

In addition, the light emitting unit 20 includes 12 setting thyristors S1 to S12. In a case where the setting thyristors S1 to S12 are not distinguished from each other, the setting thyristors S1 to S12 are referred to as setting thyristors S below.

Each of the setting thyristors S is connected in series with the VCSEL of the light emitting section 21 to which the same number is assigned. It should be noted that the setting thyristors S1 to S12 are stacked on the VCSEL1 to VCSEL12 of the respective light emitting sections 21-1 to 21-12 having the same number. That is, each of the light emitting sections 21 includes the setting thyristor S and the VCSEL.

The transfer unit 30 is driven to sequentially transfer the ON state, and switches each of the light emitting sections 21-1 to 21-12 of the light emitting unit 20 between a light emitting state and a non-light emitting state. In the light emitting chip 10 in the present exemplary embodiment, the transfer unit 30 is disposed around each light emitting section 21 of the light emitting unit 20.

The transfer unit 30 includes 12 transfer thyristors T1 to T12. In a case where the transfer thyristors T1 to T12 are not distinguished from each other, the transfer thyristors T1 to T12 are referred to as transfer thyristors T below. In addition, the transfer unit 30 includes 12 lower diodes UD1 to UD12. In a case where the lower diodes UD1 to UD12 are not distinguished from each other, the lower diodes UD1 to UD12 are referred to as lower diodes UD below.

Regarding the transfer thyristors T1 to T12 and the lower diodes UD1 to UD12, the transfer thyristor T and the lower diode UD having the same number are connected in series. It should be noted that the transfer thyristor T is stacked on the lower diode UD formed on the substrate 80.

In addition, the transfer unit 30 includes coupling diodes D1 to D11 between each of pairs in a case where two of the transfer thyristors T1 to T12 are paired in order of the numbers. In a case where the coupling diodes D1 to D11 are not distinguished from each other, the coupling diodes D1 to D11 are referred to as coupling diodes D below.

Further, the transfer unit 30 includes power source line resistors Rg1 to Rg12. In a case where the power source line resistors Rg1 to Rg12 are not distinguished from each other, the power source line resistors Rg1 to Rg12 are referred to as power source line resistors Rg below.

Further, the transfer unit 30 includes one start diode SD.

Furthermore, the transfer unit 30 includes current limiting resistors R1 and R2 provided to prevent an excessive current from flowing between a first transfer signal line 72 to which the first transfer signal $\varphi 1$ to be described later is supplied and a second transfer signal line 73 to which the second transfer signal $\varphi 2$ is supplied.

In the light emitting chip 10 in the present exemplary embodiment, the transfer thyristors T1 to T12, the lower diodes UD1 to UD12, the coupling diodes D1 to D11, the power source line resistors Rg1 to Rg12, the start diode SD, and the current limiting resistors R1 and R2 in the transfer unit 30 are separately disposed at two places on the substrate 80. It should be noted that, in the light emitting chip 10, the transfer thyristors T1 to T6, the lower diodes UD1 to UD6, the coupling diodes D1 to D6, the power source line resistors Rg1 to Rg6, the start diode SD, and the current limiting resistor R1 of the transfer unit 30 and the transfer thyristors T7 to T12, the lower diodes UD7 to UD12, the coupling diodes D7 to D11, the power source line resistors Rg7 to Rg12, and the current limiting resistor R2 are separately disposed at positions facing each other with the light emitting unit 20 interposed.

As shown in Fig. 4A, in the light emitting chip 10, the transfer thyristors T1 to T6, the lower diodes UD1 to UD6, the coupling diodes D1 to D6, the power source line resistors Rg1 to Rg6, the start diode SD, and the current limiting resistor R1 in the transfer unit 30 are disposed on the +y direction side with respect to the light emitting unit 20.

It should be noted that the transfer thyristors T1 to T6, the lower diodes UD1 to UD6, the coupling diodes D1 to D6, and the power source line resistors Rg1 to Rg6 are disposed on the +y direction side of the light emitting unit 20 to be arranged in the order of the numbers from the -x direction side to the +x direction side. In addition, the transfer thyristors T1 to T6, the lower diodes UD1 to UD6, the coupling diodes D1 to D6, and the power source line resistors Rg1 to Rg6 are each disposed on the +y direction side of the light emitting sections 21-1 to 21-6 to which the same number of the light emitting unit 20 is assigned.

Further, the start diode SD and the current limiting resistor R1 are disposed on the -x direction side of the transfer thyristor T1.

In addition, as shown in Fig. 4B, in the light emitting chip 10, the transfer thyristors T7 to T12, the lower diodes UD7 to UD12, the coupling diodes D7 to D11, the power source line resistors Rg7 to Rg12, and the current limiting resistor R2 in the transfer unit 30 are disposed on the -y direction side with respect to the light emitting unit 20.

It should be noted that the transfer thyristors T7 to T12, the lower diodes UD7 to UD12, the coupling diodes D7 to D11, and the power source line resistors Rg7 to Rg12 are disposed on the -y direction side of the light emitting unit 20 in the order of the numbers from the +x direction side to the -x direction side. In addition, the transfer thyristors T7 to T12, the lower diodes UD7 to UD12, the coupling diodes D7 to D11, and the power source line resistors Rg7 to Rg12 are each disposed on the +y direction side of the light emitting sections 21-7 to 21-12 to which the same number of the light emitting unit 20 is assigned.

Further, the current limiting resistor R2 is disposed on the -x direction side of the transfer thyristor T12.

In the transfer unit 30, the transfer thyristors T1 to T6, the lower diodes UD1 to UD6, the coupling diodes D1 to D6, the power source line resistors Rg1 to Rg6, the start diode SD, and the current limiting resistor R1 that are disposed on the +y direction side with respect to the light emitting unit 20 in the light emitting chip 10 may be referred to as a first transfer unit 30A.

The first transfer unit 30A is provided along one side of two sides of the rectangular substrate 80 extending in the x direction.

Similarly, in the transfer unit 30, the transfer thyristors T7 to T12, the lower diodes UD7 to UD12, the coupling diodes D7 to D11, the power source line resistors Rg7 to Rg12, and the current limiting resistor R2 that are disposed on the -y direction side with respect to the light emitting unit 20 in the light emitting chip 10 may be referred to as a second transfer unit 30B.

The second transfer unit 30B is provided along the other side of the two sides of the rectangular substrate 80 extending in the x direction, the other side being opposite to the one side on which the first transfer unit 30A is provided.

The first transfer unit 30A is an example of a first switching unit that switches the light emitting section 21-1 to 21-6, which is an example of the first light emitting sections, between the light emitting state and the non-light emitting state. In addition, the second transfer unit 30B is an example of a second switching unit that switches the light emitting section 21-7 to 21-12, which is an example of the second light emitting sections, between the light emitting state and the non-light emitting state.

The first transfer unit 30A and the second transfer unit 30B are connected to each other by a power source line 71, a first transfer signal line 72, a second transfer signal line 73, and a lighting signal line 75, which will be described later. The power source line 71, the first transfer signal line 72, the second transfer signal line 73, and the lighting signal line 75 are examples of wirings connecting the first switching unit and the second switching unit.

The VCSEL, the lower diode UD, the coupling diode D, and the start diode SD are two-terminal semiconductor elements including an anode terminal and a cathode terminal. In addition, the setting thyristor S and the transfer thyristor T are three-terminal semiconductor elements including an anode terminal, a gate terminal, and a cathode terminal. The anode terminal, the cathode terminal, and the gate terminal may be referred to as an anode, a cathode, and a gate below, respectively, by omitting the word of the terminal.

In the light emitting chip 10 of the present exemplary embodiment, the VCSEL, the setting thyristor S, the lower diode UD, the transfer thyristor T, the coupling diode D, the power source line resistor Rg, and the start diode SD each are configured as an integrated circuit by a semiconductor stacked body epitaxially grown on the substrate 80 which is a common semiconductor substrate. Here, the semiconductor stacked body is constituted by a group III-V compound semiconductor such as GaAs, AlGaAs, and AlAs, for example.

The connection portion 40 connects the first transfer unit 30A of the transfer unit 30 with the light emitting section 21-1 to 21-6 of the light emitting unit 20, and connects the second transfer unit 30B of the transfer unit 30 with the light emitting section 21-7 to 21-12 of the light emitting unit 20.

The connection portion 40 includes signal lines 41-1 to 41-6 that connect the transfer thyristors T1 to T6 of the first transfer unit 30A with the light emitting sections 21-1 to 21-6 having the identical numbers. The signal lines 41-1 to 41-6 connect the transfer thyristors T1 to T6 of the first transfer unit 30A with the setting thyristors S1 to S6 of the light emitting sections 21-1 to 21-6 having the identical numbers belonging to the light emitting section group 21A.

In addition, the connection portion 40 includes signal lines 41-7 to 41-12 that connect the transfer thyristors T7 to T12 of the second transfer unit 30B with the light emitting sections 21-7 to 21-12 having the identical numbers. The signal lines 41-7 to 41-12 connect the transfer thyristors T7 to T12 of the second transfer unit 30B with the setting thyristors S7 to S12 of the light emitting sections 21-7 to 21-12 having the identical numbers belonging to the light emitting section group 21B.

In a case where the signal lines 41-1 to 41-12 are not distinguished from each other, the signal lines 41-1 to 41-12 are referred to as signal lines 41.

In this example, the signal lines 41-1 to 41-6 of the connection portion 40 are disposed on the +y direction side of the light emitting unit 20. In addition, the signal lines 41-7 to 41-12 of the connection portion 40 are disposed on the -y direction side of the light emitting unit 20.

In addition, in the light emitting chip 10 in the present exemplary embodiment, the signal lines 41-1 to 41-12 of the connection portion 40 are not provided between the light emitting sections 21 of the light emitting unit 20.

The signal line 41 of the connection portion 40 is formed, for example, by performing vapor deposition of contact metal such as copper or aluminum. In a case where the signal line 41 is formed with the vapor-deposited contact metal, the signal line 41 has a smaller thickness than the wirings such as the power source line 71, the first transfer signal line 72, the second transfer signal line 73, and the lighting signal line 75, which will be described later. Therefore, the electrical resistance of the signal line 41 is larger than the electrical resistance of the wirings, such as the power source line 71, the first transfer signal line 72, the second transfer signal line 73, and the lighting signal line 75.

(Optical System 11)

The optical system 11 is disposed on the +z direction side which is a downstream side in a direction in which each light emitting section 21 of the light emitting unit 20 emits light, with respect to the light emitting chip 10. The optical system 11 expands an irradiation range of light emitted from each light emitting section 21 of the light emitting chip 10 as the light goes in the +z direction.

As the optical system 11, an optical member such as a diffusion plate that is provided on an optical path of the light to diffuse the light with scattering or the like, and a diffractive optical element (DOE) or/and a lens that changes an angle of the incident light and emits the light can be used.

In the light source device 1, an irradiation surface at a certain distance from the light source device 1 in the +z direction is irradiated with light that is emitted from each light emitting section 21 of the light emitting chip 10 and has the irradiation range expanded by the optical system 11. It should be noted that different sections of the irradiation surface are irradiated with light emitted from each light emitting section 21 of the light emitting chip 10. That is, the irradiation surface is divided into a plurality of irradiation sections corresponding to the plurality of light emitting sections 21 of the light emitting chip 10.

(Connection Relationship in Light Emitting Chip 10)

Next, the electrical connection of each element in the light emitting chip 10 will be described.

Each anode of the VCSEL and the lower diode UD is connected to the substrate 80 (anode common).

The reference potential Vsub is supplied to the anodes through a rear surface electrode 91 which is a Vsub terminal provided on the rear surface of the substrate 80.

Then, each cathode of the VCSEL is connected to the anode of the setting thyristor S. Further, each cathode of the lower diode UD is connected to the anode of the transfer thyristor T.

In addition, the connection is a configuration in a case where the p-type substrate 80 is used. In a case where an n-type substrate is used, the polarities are reversed. In a case where an intrinsic (i) type substrate to which no impurities are added is used, a terminal for supplying the reference potential Vsub is provided on a side of the substrate on which the light emitting unit 20 and the transfer unit 30 are provided.

According to arrangement of the transfer thyristors T, the cathodes of the transfer thyristors T1, T3, T5, T7, T9, and T11 having odd numbers are connected to the first transfer signal line 72. Then, the first transfer signal line 72 is connected to the $\varphi 1$ terminal with the current limiting resistor R1 interposed therebetween. The first transfer signal $\varphi 1$ is supplied to the $\varphi 1$ terminal from the transfer signal generation unit 120 of the control unit 12.

On the other hand, along the arrangement of the transfer thyristors T, the cathodes of the transfer thyristors T2, T4, T6, T8, T10, and T12 having even numbers are connected to the second transfer signal line 73. The second transfer signal line 73 is connected to the cp2 terminal with the current limiting resistor R2 interposed between the second transfer signal line 73 and the cp2 terminal. The second transfer signal cp2 is supplied to the cp2 terminal from the transfer signal generation unit 120 of the control unit 12.

Each cathode of the setting thyristor S is connected to the lighting signal line 75. The lighting signal line 75 is connected to the φI terminal. In the light emitting chip 10, the lighting signal φI from the lighting signal generation unit 140 of the control unit 12 is supplied to the φI terminal with a current limiting resistor RI interposed. The current limiting resistor RI is provided on the outside of the light emitting chip 10. The lighting signal φI supplies a current for lighting to the VCSEL.

Gates Gt1 to Gt12 of the transfer thyristors T1 to T12 are connected to the gates Gs1 to Gs12 of the setting thyristors S1 to S12 having the same number in a one-to-one manner, respectively. As a result, the gates Gt1 to Gt12 and the gates Gs1 to Gs12 having the same number have electrically the same potential. As a result, for example, the gates Gt1 to Gt12 (gates Gs1 to Gs12) are referred to as gates Gt1 (gate Gs1) to indicate that the electric potentials are identical.

In a case where the gates Gt1 to Gt12 are not distinguished from each other, the gates Gt1 to Gt12 are referred to as gates Gt. In addition, in a case where the gates Gs1 to Gs12 are not distinguished from each other, the gates Gs1 to Gs12 are referred to as gates Gs.

The coupling diodes D1 to D11 are connected between the gates Gt in which the gates Gt1 to Gt12 of the transfer thyristors T1 to T12 are paired by two in order of the numbers. That is, the coupling diodes D1 to D11 are directly connected so as to be interposed between the gates Gt1 to Gt12, respectively. Then, the direction of the coupling diode D1 is connected in a direction in which a current flows from the gate Gt1 to the gate Gt2. The similar configuration is applied to the other coupling diodes D2 to D11.

The gate Gt (gate Gs) of the transfer thyristor T is connected to a power source line 71 with the power source line resistor Rg interposed therebetween and provided corresponding to each of the transfer thyristors T. The power source line 71 is connected to the Vga terminal. The power source potential Vga is supplied to the Vga terminal from the power source potential supply unit 170 of the control unit 12.

The gate Gt1 of the transfer thyristor T is connected to the cathode of the start diode SD. On the other hand, the anode of the start diode SD is connected to the second transfer signal line 73.

Subsequently, a cross-sectional structure of the light emitting chip 10 will be described.

In the light emitting chip 10, a p-type anode layer 81, a light emission layer 82, and an n-type cathode layer 83 constituting the VCSEL and the lower diode UD are sequentially provided on the p-type substrate 80. In the light emitting chip 10 in the present exemplary embodiment, the p-type anode layer 81 and the n-type cathode layer 83 are each configured by a distributed Bragg reflector (DBR) layer in which a plurality of semiconductor layers having a difference in refractive index are stacked. Thus, the p-type anode layer 81 is referred to as a p-anode (DBR) layer 81 below. Similarly, the n-type cathode layer 83 is referred to as an n-cathode (DBR) layer 83.

In the light emitting chip 10, a tunnel junction layer 84 is provided on the n-cathode (DBR) layer 83.

Further, in the light emitting chip 10, a p-type anode layer 85, an n-type gate layer 86, a p-type gate layer 87, and an n-type cathode layer 88 constituting the setting thyristor S, the transfer thyristor T, the coupling diode D, and the power source line resistor Rg are provided on the tunnel junction layer 84 in this order. The p-type anode layer 85 is referred to as a p-anode layer 85, the n-type gate layer 86 is referred to as an n-gate layer 86, the p-type gate layer 87 is referred to as a p-gate layer 87, and the n-type cathode layer 88 is referred to as an n-cathode layer 88.

Elements such as the VCSEL, the lower diode UD, the setting thyristor S, the transfer thyristor T, and the coupling diode D are constituted of a plurality of islands separated by removing a part of each of the above layers through etching. The island may be referred to as a mesa, and the etching, which forms an island (mesa), may be referred to as a mesa etching.

In the light emitting chip 10, the islands and the wirings such as the power source line 71, the first transfer signal line 72, the second transfer signal line 73, and the lighting signal line 75 are connected via a through-hole provided in a protective layer. The wirings such as the power source line 71, the first transfer signal line 72, the second transfer signal line 73, and the lighting signal line 75 are formed by, for example, gold plating or the like.

In the following description, the protective layer and the through-hole will not be described.

In addition, as shown in Fig. 5, the rear surface electrode 91 as a Vsub terminal is provided on the rear surface of the substrate 80.

Here, the notation of the p-anode (DBR) layer 81 and the n-cathode (DBR) layer 83 corresponds to functions in a case of constituting the VCSEL and the lower diode UD. That is, the p-anode (DBR) layer 81 functions as an anode, and the n-cathode (DBR) layer 83 functions as a cathode.

Further, the notations of the p-anode layer 85, the n-gate layer 86, the p-gate layer 87, and the n-cathode layer 88 correspond to functions in a case of constituting the setting thyristor S and the transfer thyristor T. That is, the p-anode layer 85 functions as an anode, the n-gate layer 86 and the p-gate layer 87 function as a gate, and the n-cathode layer 88 functions as a cathode.

In a case where each of the above-mentioned layers constitutes the coupling diode D and the power source line resistor Rg, the layers have different functions as described later.

As described below, the plurality of islands included in the light emitting chip 10 include islands which do not include a part of the layer among the p-anode (DBR) layer 81, the light emission layer 82, the n-cathode (DBR) layer 83, the tunnel junction layer 84, and the p-anode layer 85, the n-gate layer 86, the p-gate layer 87, and the n-cathode layer 88. For example, islands 301 and 302 to be described later do not include a part of the n-cathode layer 88.

Next, an example of a planar layout of the light emitting chip 10 will be described with reference to Fig. 3, Fig. 4A, and Fig. 4B.

The setting thyristor S1 and VCSEL1 of the light emitting section 21 are provided at the island 301. The transfer thyristor T1 and the coupling diode D1 are provided at the island 302. The island 303 is provided with the power source line resistor Rg1. An island 304 is provided with the start diode SD. An island 305 is provided with the current limiting resistor R1, and the island 306 is provided with the current limiting resistor R2.

The plurality of islands in a similar manner to the islands 301, 302, and 303 are formed in parallel on the light emitting chip 10. The VCSEL2 to VCSEL12, the setting thyristors S2 to S12, the lower diodes UD2 to UD12, the transfer thyristors T2 to T12, the coupling diodes D2 to D11, and the like are provided at the islands in the similar manner to the islands 301, 302, and 303.

Here, the islands 301 to 306 will be described in detail with reference to Fig. 3, Fig. 4A, Fig. 5, and the like.

As shown in Fig. 5, the VCSEL1 provided at the island 301 is constituted of the p-anode (DBR) layer 81, the light emission layer 82, and the n-cathode (DBR) layer 83. The setting thyristor S is constituted of the p-anode layer 85, the n-gate layer 86, the p-gate layer 87, and the n-cathode layer 88 which are stacked with the tunnel junction layer 84 interposed therebetween and stacked on the n-cathode (DBR) layer 83 of the VCSEL1.

The n-cathode (DBR) layer 83 of the VCSEL includes a current narrowing layer that narrows the current, as shown by black shading in Fig. 5. The current narrowing layer is a current blocking portion $\beta$ in which a current is unlikely to flow since a portion of a semiconductor layer constituting the n-cathode (DBR) layer exposed through mesa etching is oxidized from the outer periphery. On the other hand, a central portion in which a part of the semiconductor layer constituting the n-cathode (DBR) layer is not oxidized is a current passage portion $\alpha$ through which a current is likely to flow. As shown in the VCSEL1 of Fig. 4A, the circular inner side on the inner peripheral side is the current passage portion $\alpha$, and the circular outer side is the current blocking portion $\beta$. The current blocking portion $\beta$ does not need to completely block the flow of the current, and it is sufficient that the current blocking portion $\beta$ causes the current to concentrate on the current passage portion $\alpha$. That is, it is sufficient that the current blocking portion $\beta$ is unlikely to flow a current than the current passage portion $\alpha$.

By providing the current blocking portion $\beta$, power consumed for the non-emission recombination is suppressed. The current blocking portion $\beta$ is provided to achieve low power consumption and improvement of light extraction efficiency. It should be noted that the light extraction efficiency is an intensity of light that can be extracted per power.

In addition, in the setting thyristor S1, an n-type ohmic electrode 321 is provided in a region 311 of the n-cathode layer 88. The n-type ohmic electrode will be referred to as an n-ohmic electrode below. The n-ohmic electrode 321 has a circular shape surrounding the current passage portion $\alpha$.

In addition, in the setting thyristor S1, a p-type ohmic electrode 331 is provided on the p-gate layer 87 exposed by removing the n-cathode layer 88. The p-type ohmic electrode is referred to as a p-ohmic electrode below.

In addition, in the setting thyristor S1, the n-ohmic electrode 321 is used as a cathode terminal. In addition, in the setting thyristor S1, the p-ohmic electrode 331 is used as a terminal of the gate Gs1.

In a similar manner to the VCSEL, the lower diode UD1 provided at the island 302 is constituted of the p-anode (DBR) layer 81, the light emission layer 82, and the n-cathode (DBR) layer 83. In a similar manner to the setting thyristor S1, the transfer thyristor T1 is constituted of the p-anode layer 85, the n-gate layer 86, and the p-gate layer 87, and the n-cathode layer 88, which are stacked with the tunnel junction layer 84 interposed therebetween and stacked on the n-cathode (DBR) layer 83 of the lower diode UD1.

In addition, an n-ohmic electrode 323 is provided on a region 313 on the n-type cathode layer 88 in the transfer thyristor T1.

In addition, a p-ohmic electrode 332 is provided on the p-gate layer 87 exposed by removing the n-cathode layer 88 in the transfer thyristor T1.

In addition, the transfer thyristor T1 includes the n-ohmic electrode 323 as a cathode terminal. In addition, in the transfer thyristor T1, the p-ohmic electrode 332 is used as a terminal of the gate Gt1.

In a similar manner, the coupling diode D1, which is provided at the island 302, is constituted of the p-gate layer 87 and the n-cathode layer 88.

In addition, an n-ohmic electrode 324 is provided on a region 314 on the n-cathode layer 88 in the coupling diode D1.

In the coupling diode D1, the n-ohmic electrode 324 is used as a cathode terminal. Further, in the coupling diode D1, the p-ohmic electrode 332 is used as an anode terminal. Here, the anode terminal of the coupling diode D1 is identical to the gate Gt1.

The power source line resistor Rg1, which is provided at the island 303, is constituted by the p-gate layer 87. That is, regarding the power source line resistor Rg 1, a pair of p-ohmic electrodes 333 and 334 are provided on the p-gate layer 87 exposed by removing the n-cathode layer 88. The power source line resistor Rg1 is provided by using the p-gate layer 87 between the pair of p-ohmic electrodes 333 and 334 as a resistor.

The start diode SD, which is provided at the island 304, is constituted of the p-gate layer 87 and the n-cathode layer 88. That is, in the start diode SD, an n-ohmic electrode 325 provided on a region 315 of the n-cathode layer 88 serves as a cathode terminal. Further, the start diode SD uses, as the anode terminal, the p-ohmic electrode 335 provided on the p-gate layer 87 exposed by removing the n-cathode layer 88.

The current limiting resistor R1 provided at the island 305 and the current limiting resistor R2 provided at the island 306 are provided in the same manner as the power source line resistor Rg1 provided at the island 303, and each resistor uses the p-gate layer 87 between the two p-ohmic electrodes (unsigned) as a resistor.

Next, a connection relationship between the elements will be described.

The n-ohmic electrode 321 which is the cathode terminal of the setting thyristor S of the light emitting section 21-1 provided at the island 301 is connected to the lighting signal line 75.

The cathode terminal of the setting thyristor S of the other light emitting section 21 provided in the similar island to the island 301 is connected to the lighting signal line 75.

The first transfer signal line 72 includes a first extending portion 72a that extends in the x direction on the +y direction side of the light emitting unit 20, and a second extending portion 72b that extends in the x direction on the -y direction side of the light emitting unit 20. In addition, the first transfer signal line 72 includes a connection portion 72c that extends in the y direction on the +x direction side of the light emitting unit 20 and connects an end portion of the first extending portion 72a on the +x direction side and an end portion of the second extending portion 72b on the +x direction side. It should be noted that the first extending portion 72a of the first transfer signal line 72 is provided to extend along the transfer thyristors T1 to T6 arranged in the x direction. In addition, the second extending portion 72b of the first transfer signal line 72 is provided to extend along the transfer thyristors T7 to T11 arranged in the x direction.

The first transfer signal line 72 is connected to the n-ohmic electrode 323 which is the cathode terminal of the transfer thyristor T1 provided at the island 302. The first transfer signal line 72 is connected to the cathode terminal of another transfer thyristor T having an odd number, which is provided at the island similar to the island 302. Specifically, the cathode terminals of the transfer thyristors T1, T3, and T5 are connected to the first extending portion 72a of the first transfer signal line 72. In addition, the cathode terminals of the transfer thyristors T7, T9, and T11 are connected to the second extending portion 72b of the first transfer signal line 72.

Further, the first transfer signal line 72 is connected to the φ1 terminal with the current limiting resistor R1 interposed between the first transfer signal line 72 and the φ1 terminal. The current limiting resistor R1 is provided at the island 305. It should be noted that the end portion of the first transfer signal line 72 on the -x direction side at the first extending portion 72a is connected to the φ1 terminal.

The second transfer signal line 73 includes a first extending portion 73a that extends in the x direction on the +y direction side of the light emitting unit 20, and a second extending portion 73b that extends in the x direction on the -y direction side of the light emitting unit 20. In addition, the second transfer signal line 73 includes a connection portion 73c that extends in the y direction on the +x direction side of the light emitting unit 20 and connects an end portion of the first extending portion 73a on the +x direction side and an end portion of the second extending portion 73b on the +x direction side. It should be noted that the first extending portion 73a of the second transfer signal line 73 is provided to extend along the transfer thyristors T1 to T6 arranged in the x direction. In addition, the second extending portion 73b of the second transfer signal line 73 is provided to extend along the transfer thyristors T7 to T12 arranged in the x direction.

In this example, the first extending portion 73a, the connection portion 73c, and the second extending portion 73b of the second transfer signal line 73 are provided on the inner peripheral side of the light emitting chip 10 with respect to the second extending portion 72b, the connection portion 72c, and the first extending portion 72a of the first transfer signal line 72.

The second transfer signal line 73 is connected to an n-ohmic electrode (with no reference symbol) which is a cathode terminal of an even-numbered transfer thyristor T which is provided on an island with no reference symbol. Specifically, the first extending portion 73a of the second transfer signal line 73 is connected to the cathode terminals of the transfer thyristor T6, T4, and T2. In addition, the second extending portion 73b of the second transfer signal line 73 is connected to the cathode terminals of the transfer thyristors T12, T10, and T8.

Further, the second transfer signal line 73 is connected to the φ2 terminal with the current limiting resistor R2 interposed between the second transfer signal line 73 and the φ2 terminal. The current limiting resistor R2 is provided at the island 306. It should be noted that the end portion of the second transfer signal line 73 on the -x direction side at the second extending portion 73b is connected to the φ2 terminal.

Further, the second transfer signal line 73 is connected to the p-ohmic electrode 335 which is the anode terminal of the start diode SD provided at the island 304. It should be noted that the end portion of the second transfer signal line 73 on the -x direction side of the first extending portion 73a is connected to the p-ohmic electrode 335 which is the anode terminal of the start diode SD.

The power source line 71 includes a first extending portion 71a that extends in the x direction on the +y direction side of the light emitting unit 20, and a second extending portion 71b that extends in the x direction on the -y direction side of the light emitting unit 20. In addition, the power source line 71 includes a connection portion 71c that extends in the y direction on the +x direction side of the light emitting unit 20 and connects an end portion of the first extending portion 71a on the +x direction side and an end portion of the second extending portion 71b on the +x direction side. It should be noted that the first extending portion 71a of the power source line 71 is provided to extend along the power source line resistors Rg1 to Rg6 arranged in the x direction. In addition, the second extending portion 71b of the power source line 71 is provided to extend along the power source line resistors Rg7 to Rg12 arranged in the x direction.

The power source line 71 is connected to the p-ohmic electrode 334 which is one terminal of the power source line resistor Rg1 provided at the island 303. The power source line 71 is connected to p-ohmic electrodes (with no reference symbol) which are terminals of the other power source line resistors Rg2 to Rg12.

Specifically, the first extending portion 71a of the power source line 71 is connected to terminals of the power source line resistors Rg2 to Rg6. In addition, the second extending portion 71b of the power source line 71 is connected to terminals of the power source line resistor Rg7 to Rg12.

Further, the power source line 71 is connected to the Vga terminal. It should be noted that the end portion of the power source line 71 on the -x direction side at the first extending portion 71a is connected to the Vga terminal.

The p-ohmic electrode 332 which is the anode terminal of the transfer thyristor T1 provided at the island 302 is connected to the p-ohmic electrode 333 which is the other terminal of the power source line resistor Rg1 provided at the island 303, by a connection wiring 77. In addition, the anode terminals of the other transfer thyristors T2 to T12 provided at the island similar to the island 302 are connected to the other terminals of the power source line resistors Rg2 to Rg12 provided at the island similar to the island 303 by the connection wiring 77.

In addition, the p-ohmic electrode 332 which is the anode terminal of the transfer thyristor T1 provided at the island 302 is connected to the n-ohmic electrode 325 which is the cathode terminal of the start diode SD provided at the island 304, by a connection wiring 78.

Further, the n-ohmic electrode 324 which is the cathode terminal of the coupling diode D1 provided at the island 302 is connected to the p-ohmic electrode (with no reference symbol) which is the gate terminal Gt2 of the adjacent transfer thyristor T2 by a connection wiring 79. Similarly, the cathode terminal of the coupling diodes D2 to D11 is connected to the gate terminal Gt3 to Gt12 of the transfer thyristors T3 to T12 having the numbers larger by one, by the connection wiring 79. In the light emitting chip 10 in the present exemplary embodiment, the coupling diode D6 and the transfer thyristor T7 are disposed at positions spaced apart from each other in the y direction with the light emitting unit 20 interposed between the coupling diode D6 and the transfer thyristor T7. Therefore, as shown in Fig. 3, the connection wiring 79 that connects the cathode terminal of the coupling diode D6 and the gate terminal Gt7 of the transfer thyristor T7 has a shape extending in the y direction on the +x direction side of the light emitting unit 20.

In addition, the p-ohmic electrode 331 which is the gate terminal Gs1 of the setting thyristor S1 provided at the island 301 is connected to the p-ohmic electrode 332 which is the gate terminal Gt1 of the transfer thyristor T1 provided at the island 302, by the signal line 41-1.

The gate terminals Gs2 to G12 of the other setting thyristors S2 to S12 provided at the island similar to the island 301 are connected to the gate terminals Gt2 to Gt12 of the transfer thyristors T2 to T12 having the same numbers provided at the island similar to the island 302, by the signal lines 41-2 to 41-12.

In the light emitting chip 10 in the present exemplary embodiment, the gate terminals Gs1 to Gs12 of the setting thyristors S1 to S12 and the gate terminals Gt1 to Gt12 of the transfer thyristors T1 to T12, the setting thyristors S1 to S12 and the transfer thyristors T1 to T12 having the same numbers, are disposed to be arranged in the y direction. As a result, the signal lines 41-1 to 41-12 have a linear shape extending in the y direction from the gate terminal Gs1 to Gs12 toward the gate terminal Gt1 to Gt12, respectively.

In addition, in the light emitting chip 10 in the present exemplary embodiment, the connection portion 71c of the power source line 71, the connection portion 72c of the first transfer signal line 72, and the connection portion 73c of the second transfer signal line 73, which are examples of the wiring connecting the first transfer unit 30A and the second transfer unit 30B, are provided along one side of the rectangular substrate 80 extending in the y direction.

Further, in the light emitting chip 10 in the present exemplary embodiment, the φ1 terminal, the φ2 terminal, the Vga terminal, and the φI terminal, which are examples of the terminals that receive the supply of the power to the light emitting unit 20, are provided along the other side of the rectangular substrate 80 extending in the y direction.

It should be noted that the above-mentioned connection and configuration are for a case of using the p-type substrate 80, and the polarities thereof are opposite to each other in a case of using the n-type substrate. Further, in a case of using an i-type substrate, a terminal for supplying the reference potential Vsub is provided on a side of the substrate on which the light emitting unit 20, the transfer unit 30, and the connection portion 40 are provided. In addition, the connection and configuration are the same as either in the case of using the p-type substrate or in the case of using the n-type substrate.

(Thyristor)

Subsequently, basic operations of the transfer thyristor T and the setting thyristor S of the light emitting chip 10 will be described. The transfer thyristor T and the setting thyristor S may be simply referred to as a thyristor below. As described above, the thyristor is a semiconductor element having three terminals of the anode terminal, the cathode terminal, and the gate terminal, and is configured by stacking, for example, the p-anode layer 83 and the p-gate layer 87, which are p-type semiconductor layers made of GaAs, AlGaAs, AlAs, and the like, and the n-gate layer 86 and n-cathode layer 88, which are n-type semiconductor layers, on the substrate 80. That is, the thyristor has a pnpn structure. Here, a forward electric potential (diffusion electric potential) Vd of a pn junction constituted of the p-type semiconductor layer and the n-type semiconductor layer will be described as 1.5 V as an example.

The following description will be made, for example, on the assumption as follows. The reference potential Vsub supplied to the rear surface electrode 91 (see Fig. 5) which is a Vsub terminal is set to 0 V as a high-level potential (referred to as "H" below). The power source potential Vga supplied to the Vga terminal is set to -5 V as a low-level potential (referred to as "L" below). As a result, the potentials may be referred to as "H" (0 V) or "L" (-5 V).

First, an operation of a single thyristor will be described. Here, the anode of the thyristor is set to 0V.

The thyristor in an OFF state in which no current flows between an anode and the cathode transitions to an ON state (turns on) in a case where an electric potential lower than a threshold voltage (a negative electric potential having a large absolute value) is applied to the cathode. Here, a threshold voltage of the thyristor is a value obtained by subtracting the forward electric potential Vd (1.5 V) of the pn junction from the electric potential of the gate.

In the ON state, the gate of the thyristor has an electric potential close to an electric potential of the anode terminal. Here, since the anode is set to 0V, the gate is supposed to be 0V. Further, the cathode of the thyristor in the ON state has an electric potential close to an electric potential obtained by subtracting the forward electric potential Vd (1.5 V) of the pn junction from an electric potential of the anode. Here, since the anode is set to 0 V, the cathode of the thyristor in the ON state has an electric potential close to -1.5 V (a negative electric potential having an absolute value greater than 1.5 V). It should be noted that the electric potential of the cathode is set in relation to the power source that supplies a current to the thyristor in the ON state.

In a case where the cathode of the thyristor in the ON state is set to an electric potential (a negative electric potential with a small absolute value, 0 V, or a positive electric potential) higher than the electric potential (an electric potential close to -1.5 V described above) required to maintain the ON state, the thyristor transitions (is turned off) to the OFF state.

In contrast, in a case where an electric potential lower than the electric potential required to maintain the ON state (a negative electric potential with a large absolute value) is continuously applied to the cathode of the thyristor in the ON state and a current capable of maintaining the ON state (maintenance current) is supplied, the thyristor maintains the ON state.

Next, an operation thereof in a state where the VCSEL and the setting thyristor S are stacked will be described.

The setting thyristor S and the VCSEL are stacked and connected in series. Accordingly, an electric potential of the lighting signal φI is divided between the VCSEL and the setting thyristor S. Here, description will be given under an assumption that the voltage applied to the VCSEL is -1.7V Then, in a case where the setting thyristor S is in the OFF state, -3.3 V is applied to the setting thyristor S.

As described above, in a case where an absolute value of the threshold voltage of the setting thyristor S in the OFF state is greater than an absolute value of -3.3 V, the electric potential applied to the cathode of the setting thyristor S is lower than the threshold voltage. Thus, the setting thyristor S is turned on. Then, the current flows through the VCSEL and the setting thyristor S connected in series, and the VCSEL emits light. In contrast, in a case where the absolute value of the threshold voltage of the setting thyristor S is smaller than the absolute value of -3.3 V, the setting thyristor S is not turned on and maintains the OFF state.

It should be noted that in a case where the setting thyristor S is turned on, the current limiting resistor RI (see Fig. 2) lowers an absolute value of the voltage applied to the VCSEL and the setting thyristor S connected in series. However, in a case where the voltage applied to the setting thyristor S is a voltage which maintains the ON state of the setting thyristor S, the setting thyristor S maintains the ON state. As a result, the VCSEL also continues to emit light.

It should be noted that the voltage shown above is an example and may be changed in accordance with the emission wavelength and the intensity of light of the VCSEL. In such a case, it is sufficient that the electric potential ("L") of the lighting signal φI is adjusted.

(Operations of Light Source Device 1 and Light Emitting Chip 10)

Subsequently, the operations of the light source device 1 and the light emitting chip 10 will be described.

<Timing Chart>

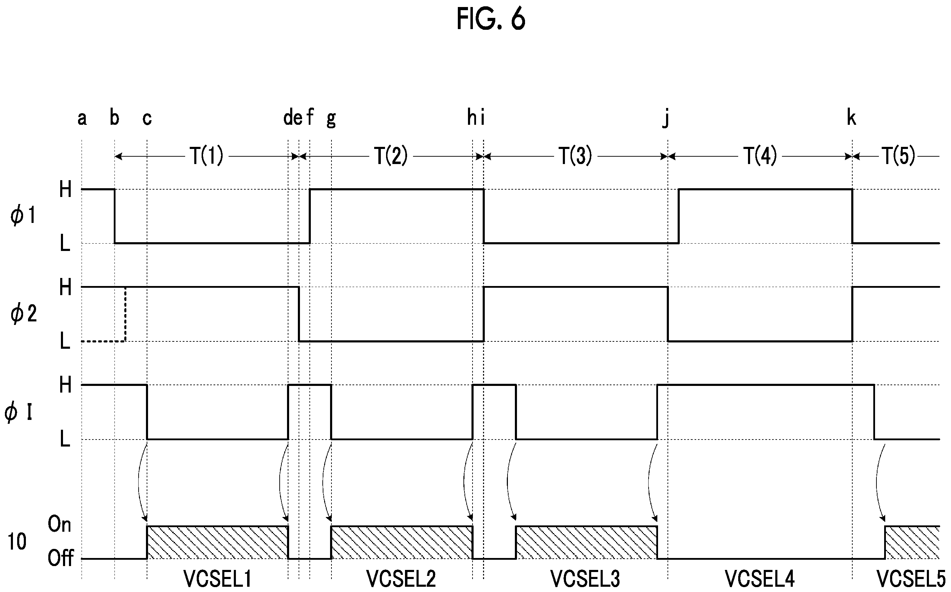

Fig. 6 is a timing chart showing an example of the operations of the light source device 1 and the light emitting chip 10. Fig. 6 is a timing chart of a portion that controls the lighting or the non-lighting of VCSEL1 to VCSEL4 in the light emitting sections 21-1 to 21-4 of the light emitting chip 10. In Fig. 6, VCSEL1, VCSEL2, and VCSEL3 are lit, and VCSEL4 is not lit.

In Fig. 6, it is assumed that the time elapses from a time a to a time k in alphabetical order. Control of lighting or non-lighting is performed on VCSEL1 in a period T(1), on VCSEL2 in a period T(2), on VCSEL3 in a period T(3), and on VCSEL4 in a period T(4). The control of lighting or non-lighting is referred to as lighting control below.

Here, the periods T(1), T(2), T(3), ... are defined as periods having the same length, and are referred to as periods T in a case where the periods are not distinguished from each other.

The first transfer signal φ1 transmitted to the φ1 terminal (see Fig. 3 and Fig. 4A) and the second transfer signal cp2 transmitted to the cp2 terminal (see Fig. 3 and Fig. 4B) are signals having two potentials including "H" (0 V) and "L" (-5 V). The first transfer signal cp 1 and the second transfer signal cp2 have waveforms repeated, for example, in units of two consecutive periods T such as the period T(1) and the period T(2).

"H" (0 V) and "L" (-5 V) may be abbreviated as "H" and "L" below.

The first transfer signal φ1 transitions from "H" (0 V) to "L" (-5 V) at a start time b in the period T(1), and transitions from "L" to "H" at a time f. Then, at an end time i in the period T(2), the transition from "H" to "L" occurs.

The second transfer signal cp2 is "H" (0 V) at the start time b in the period T(1), and transitions from "H" (0 V) to "L" (-5 V) at a time e. Then, transition from "L" to "H" occurs at the end time i in the period T(2).

Comparing the first transfer signal φ1 and the second transfer signal cp2, the second transfer signal cp2 corresponds to a signal obtained by shifting back the first transfer signal φ1 by the period T on the time axis. In contrast, a waveform of the second transfer signal cp2 indicated by the broken line in the period T(1) and a waveform thereof in the period T(2) are repeated in the period T(3) and thereafter. The waveform of the second transfer signal cp2 in the period T(1) is different from the waveform thereof in the period T(3) and thereafter. The reason for this is that the period T(1) is a period during which the light source device 1 starts an operation.

As described later, a pair of transfer signals including the first transfer signal φ1 and the second transfer signal φ2 propagates the ON states of the transfer thyristor T in order of the numbers, thereby specifying the VCSEL, which has the same number as the transfer thyristor T in the ON state, as a target of lighting or non-lighting (lighting control).

Next, the lighting signal φI supplied to the φI terminal (see Fig. 2 and Fig. 3) will be described. The lighting signal φI is a signal having two potentials including "H" (0 V) and "L" (-5 V).

Here, the lighting signal φI will be described in the period T(1) of the lighting control for the VCSEL1. The lighting signal φI is at "H" (0 V) at the start time b in the period T(1), and transitions from "H" (0 V) to "L" (-5 V) at a time c. Then, transition from "L" to "H" occurs at a time d, and "H" is maintained at the time e.

The operations of the light source device 1 and the light emitting chip 10 will be described in accordance with the timing chart shown in Fig. 6, with reference to Fig. 2. The periods T(1) and T(2) for the lighting control of the VCSEL1 and the VCSEL2 will be described below.

(1) Time a

At the time a, the reference potential supply unit 160 of the control unit 12 of the light source device 1 sets the reference potential Vsub to "H" (0 V). The power source potential supply unit 170 of the control unit 12 sets the power source potential Vga to "L" (-5 V). The transfer signal generation unit 120 of the control unit 12 sets each of the first transfer signal φ1 and the second transfer signal φ2 to "H" (0 V). Thereby, the φ1 terminal and the φ2 terminal of the light emitting chip 10 are changed to "H". The electric potential of the first transfer signal line 72 connected to the φ1 terminal with the current limiting resistor R1 interposed therebetween is also "H", and the second transfer signal line 73 connected to the φ2 terminal with the current limiting resistor R2 interposed therebetween is also at "H" (see Fig. 2).

Then, the lighting signal generation unit 140 of the control unit 12 sets the lighting signal φI to "H" (0 V). Thereby, the φI terminal of the light emitting chip 10 is changed to "H" through the current limiting resistor RI, and the lighting signal line 75 connected to the φI terminal is also at "H" (0 V).

The p-anode layer 85 which is the anode of the setting thyristor S is connected to the n-cathode (DBR) layer 83 which is the cathode of the VCSEL, with the tunnel junction layer 84 interposed between the p-anode layer 85 and the n-cathode (DBR) layer 83. The p-anode (DBR) layer 81 which is the anode of the VCSEL is connected to the Vsub terminal set to "H".

The p-anode layer 85 which is the anode of the transfer thyristor T is connected to the n-cathode (DBR) layer 83 which is the cathode of the lower diode UD, with the tunnel junction layer 84 between the p-anode layer 85 and the n-cathode (DBR) layer 83. The p-anode (DBR) layer 81 which is the anode of the lower diode UD is connected to the Vsub terminal set to "H".

The cathodes of the respective transfer thyristors T1, T3, T5, T7, T9, and T11 having an odd number are connected to the first transfer signal line 72 and are set to "H" (0 V). The cathodes of the respective transfer thyristors T2, T4, T6, T8, T10, and T12 having even numbers are connected to the second transfer signal line 73 and are set to "H". As a result, both the anode and the cathode of the transfer thyristor T are changed to "H", and the setting thyristor S is in the OFF state. Further, both the anode and the cathode of the lower diode UD are changed to "H" and the lower diode UD is also in the OFF state.

The cathode terminal of the setting thyristor S is connected to the lighting signal line 75 of "H" (0 V). Accordingly, both the anode and the cathode of the transfer thyristor T are changed to "H", and the setting thyristor S is in the OFF state. Further, both the anode and the cathode of the VCSEL are set to "H" and the VCSEL is in the OFF state.

As described above, the gate Gt1 is connected to the cathode of the start diode SD. The gate Gt1 is connected to the power source line 71 having a power source potential Vga ("L" (-5 V)) with a power source line resistor Rg1 interposed therebetween. Then, the anode terminal of the start diode SD is connected to the second transfer signal line 73 and is connected to the φ2 terminal of "H" (0 V) with the current limiting resistor R2 interposed therebetween. Accordingly, the start diode SD is forward biased, and the cathode (gate Gt1) of the start diode SD is changed to a value (-1.5 V) which is obtained by subtracting a forward electric potential Vd (1.5V) of the pn junction from the electric potential ("H" (0 V)) of the anode of the start diode SD. Further, in a case where the gate Gt1 is changed to -1.5 V, the coupling diode D1 is forward biased since the anode (gate Gt1) of the coupling diode D1 is -1.5 V and the cathode is connected to the power source line 71 ("L" (-5 V)) with the power source line resistor Rg2 interposed therebetween. Accordingly, the electric potential of the gate Gt2 is -3 V obtained by subtracting the forward electric potential Vd (1.5V) of the pn junction from the electric potential (-1.5 V) of the gate Gt1. Further, the coupling diode D2 is forward biased since the anode (gate Gt1) is -3 V and the cathode is connected to the power source line 71 ("L" (-5 V))) with the power source line resistor Rg2 interposed between the cathode and the power source line 71. Accordingly, the electric potential of the gate Gt3 is -4.5 V obtained by subtracting the forward electric potential Vd (1.5 V) of the pn junction from the electric potential (-3 V) of the gate Gt2. However, the gate Gt of which the number is 4 or more is not affected by the fact that the anode of the start diode SD is at "H" (0 V), and the electric potential of these gate Gt is changed to "L" (-5 V) which is the electric potential of the power source line 71.

It should be noted that since the gate Gt is the gate Gs, the electric potential of the gate Gs is the same as the electric potential of the gate Gt. Accordingly, the threshold voltage of the transfer thyristor T and the setting thyristor S is a value obtained by subtracting the forward electric potential Vd (1.5 V) of the pn junction from the electric potentials of the gates Gt and Gs. That is, the threshold voltages of the transfer thyristor T1 and the setting thyristor S1 are -3 V, the threshold voltages of the transfer thyristor T2 and the setting thyristor S2 are -4.5 V, the threshold voltages of the transfer thyristor T3 and the setting thyristor S3 are -6 V, and the threshold voltages of the transfer thyristors T and the setting thyristors S of which the numbers are 4 or more are -6.5 V

(2) Time b

At the time b shown in Fig. 6, the first transfer signal φ1 transitions from "H" (0 V) to "L" (-5 V). Thereby, the light source device 1 starts an operation.

In a case where the first transfer signal φ1 transitions from "H" to "L", the potential of the first transfer signal line 72 transitions from "H" (0 V) to "L" (-5 V) through the φ1 terminal and the current limiting resistor R1. Then, since the voltage applied to the transfer thyristor T1 is -3.3 V, the transfer thyristor T1 having the threshold voltage of -3 V is turned on. In such a case, a current flows through the lower diode UD1. Therefore, the transition from the OFF state to the ON state occurs. By turning on the transfer thyristor T1, the electric potential of the first transfer signal line 72 is changed to an electric potential close to -3.2 V (a negative electric potential of which the absolute value is greater than 3.2 V), which is obtained by subtracting the forward electric potential Vd (1.5 V) of the pn junction from the electric potential (-1.7 V which is the electric potential applied to the lower diode UD1) of the anode of the transfer thyristor T1.

The transfer thyristor T3 has a threshold voltage of -6 V, and the transfer thyristors T5, T7, T9, and T11 have a threshold voltage of -6.5 V Since the voltage applied to the transfer thyristors T3, T5, T7, T9, and T11 is -1.5 V obtained by adding, to -3.2 V, 1.7 V which is the voltage applied to the VCSEL, the transfer thyristor T3 and the transfer thyristor T5 are not turned on.

On the other hand, the transfer thyristor T having an even number cannot be turned on since the second transfer signal φ2 is "H" (0 V) and the second transfer signal line 73 is at "H" (0 V).

In a case where the transfer thyristor T1 is turned on, the electric potential of the gate Gt1/Gs1 is changed to "H" (0 V) which is the electric potential of the anode of the transfer thyristor T1. Then, the electric potential of the gate Gt2 (gate Gs2) is -1.5 V, the electric potential of the gate Gt3 (gate Gs3) is -3 V, the electric potential of the gate Gt4 (gate Gs4) is -4.5 V, and the electric potential of the gate Gt (the gate Gl) of which the number is 5 or more is changed to "L".

Thereby, the threshold voltages of the setting thyristor S1 are changed to -1.5 V, the threshold voltages of the transfer thyristor T2 and the setting thyristor S2 are changed to -3 V, the threshold voltages of the transfer thyristor T3 and the setting thyristor S3 are changed to - 4.5 V, and the threshold voltages of the transfer thyristor T4 and the setting thyristors S4 are changed to -6 V, and the threshold voltages of the transfer thyristors T5 to T12 and the setting thyristors S5 to S12 are changed to -6.5 V.

However, the first transfer signal line 72 is set to -1.5 V by the transfer thyristor T1 in the ON state. Therefore, the transfer thyristor T having an odd number in the OFF state is not turned on. The second transfer signal line 73 is at "H" (0 V). Therefore, the transfer thyristor T having an even number is not turned on. The lighting signal line 75 is at "H" (0 V). Therefore, none of the VCSELs are lit.

Immediately after the time b, the transfer thyristor T1 and the lower diode UD1 are in the ON state, and the other transfer thyristors T, the lower diodes UD, the setting thyristor S, and VDSEL are in the OFF state. A time immediately after the time b refers to a time at which the thyristor and the like are changed due to the change in the potential of the signal at the time b, and then the thyristor and the like have reached a steady state.

### (3) Time c

At the time c, the lighting signal φI transitions from "H" (0 V) to "L" (-5 V).

In a case where the lighting signal φI transitions from "H" to "L", the lighting signal line 75 transitions from "H" (0 V) to "L" (-5 V) through the current limiting resistor RI and the φI terminal. Then, 3.3 V, which is the sum of the voltage applied to the VCSEL of 1.7 V, is applied to the setting thyristor S1, the setting thyristor S1 having a threshold voltage of -1.5 V is turned on, and the VCSEL1 is lit. Thereby, the electric potential of the lighting signal line 75 is changed to an electric potential close to -3.2 V. In addition, the threshold voltage of the setting thyristor S2 is -3 V. However, the voltage applied to the setting thyristor S2 is -1.5 V obtained by adding the voltage of 1.7 V applied to the VCSEL to -3.2 V As a result, the setting thyristor S2 is not turned on.

Immediately after the time c, the transfer thyristor T1, the lower diode UD1, and the setting thyristor S1 are in the ON state, and the VCSEL1 is lit.

### (4) Time d

At the time d, the lighting signal φI transitions from "L" (-5 V) to "H" (0 V).

In a case where the lighting signal φI transitions from "L" to "H", the electric potential of the lighting signal line 75 transitions from -3.2V to "H" (0 V) through the current limiting resistor RI and the φI terminal. Then, both the cathode of the setting thyristor S1 and the anode of the VCSEL1 are changed to "H". Therefore, the setting thyristor S1 is turned off and the VCSEL1 is not lit. The lighting period of the VCSEL1 is a period, in which the lighting signal φI is "L", from the time c at which the lighting signal φI transitions from "H" to "L" to the time d at which the lighting signal φI transitions from "L" to "H".

Immediately after the time d, the transfer thyristor T1 is in the ON state.

### (5) Time e

At the time e, the second transfer signal cp2 transitions from "H" (0 V) to "L" (-5 V). Here, the period T(1) for controlling lighting of the VCSEL1 ends, and the period T(2) for controlling lighting of the VCSEL2 starts.

In a case where the second transfer signal φ2 transitions from "H" to "L", the electric potential of the second transfer signal line 73 transitions from "H" to "L" via the φ2 terminal. As described above, the transfer thyristor T2 is turned on since the threshold voltage is changed to -3 V. In such a case, a current also flows through the lower diode UD2. Therefore, the transition from the OFF state to the ON state occurs.

Thus, the potential of the gate terminal Gt2 (gate terminal Gs2) is changed to "H" (0 V), the potential of the gate Gt3 (gate Gs3) is changed to -1.5 V, the potential of the gate Gt4 (gate Gs4) is changed to -3 V, the electric potential of the gate Gt5 (gate Gs5) is changed to -4.5 V, and the potentials of the gate Gt6 (gate Gs6) to the gate Gt12 (gate Gs12) are changed to -5 V.

Immediately after the time e, the transfer thyristors T1 and T2 and the lower diodes UD1 and UD2 are in the ON state.

### (6) Time f

At the time f, the first transfer signal φ1 transitions from "L" (-5 V) to "H" (0 V).

In a case where the first transfer signal φ1 transitions from "L" to "H", the electric potential of the first transfer signal line 72 transitions from "L" to "H" through the φ1 terminal. Then, both the anode and the cathode of the transfer thyristor T1 are changed to "H", such that the transfer thyristor T1 in the ON state is turned off. In such a case, both the anode and the cathode of the lower diode UD1 are also changed to "H", such that the transition from the ON state to the OFF state occurs.

Then, the electric potential of the gate Gt1 (gate Gs1) changes toward the power source potential Vga ("L" (-5 V)) of the power source line 71 through the power source line resistor Rg1. Thereby, the coupling diode D1 is in a state in which an electric potential is applied in a direction in which a current does not flow (reverse bias). Accordingly, the gate Gt1 (gate Gs1) does not have the effect that the gate Gt2 (gate Gs2) is "H" (0 V). That is, the threshold voltage of the transfer thyristor T having the gate Gt connected by the reverse bias coupling diode D is changed to -6.5 V, and the transfer thyristor T is not turned on even in a case where the first transfer signal cp 1 or the second transfer signal cp2 is changed to "L" (-5 V).

Immediately after the time f, the transfer thyristor T2 and the lower diode UD2 are in the ON state.

(7) Others

At the time g, in a case where the lighting signal φI transitions from "H" (0 V) to "L" (-5 V), the setting thyristor S2 is turned on and the VCSEL2 is lit (emits light) in the same manner as the VCSEL1 and the setting thyristor S1 at the time c.

Then, in a case where the lighting signal φI transitions from "L" (-5 V) to "H" (0 V) at the time h, the setting thyristor S2 is turned off in the same manner as the VCSEL1 and the setting thyristor S1 at the time d, and the VCSEL2 is lit off.

Further, in a case where the first transfer signal φ1 transitions from "H" (0 V) to "L" (-5 V) at the time i, the transfer thyristor T3 having a threshold voltage of -3 V is turned on in the same manner as the transfer thyristor T1 at the time b or the transfer thyristor T2 at the time e. At the time point i, the period T(2) for controlling the lighting of the VCSEL 2 ends, and the period T(3) for controlling the lighting of the VCSEL 3 starts.

Thereafter, the above-mentioned steps will be repeated.

In a case where the VCSELs are not lit (do not emit light) but remain lit off (non-lighting), similarly to the lighting signal φI shown in a range from the time j to the time k in the period T(4) for controlling the lighting of the VCSEL 4 in Fig. 6, it is sufficient that the lighting signal φI remains at "H" (0 V). By doing so, even in a case where the threshold voltage of the setting thyristor S4 is -1.5 V, the setting thyristor S4 is not turned on and the VCSEL remains lit off (non-lit).

As described above, the gate terminals Gt of the transfer thyristors T are connected to each other through the coupling diode D. Accordingly, in a case where the electric potential of the gate Gt changes, the electric potential of the gate Gs connected to the gate Gt of which the electric potential is changed via the forward bias coupling diode D changes. Then, the threshold voltage of the transfer thyristor T having the gate from which the electric potential is changed changes. In a case where the threshold voltage is higher than -3.3 V, the transfer thyristor T is turned on at a timing at which the first transfer signal φ1 or the second transfer signal φ2 transitions from "H" (0 V) to "L" (-5 V).

Then, the threshold voltage of the setting thyristor S in which the gate Gs is connected to the gate Gt of the transfer thyristor T in the ON state has a threshold voltage of -1.5 V Therefore, in a case where the lighting signal φI transitions from "H" (0 V) to "L" (-5 V), the transfer thyristor T is turned on, and the VCSEL connected in series to the setting thyristor S is turned on (emits light).

That is, the transfer thyristor T is turned on to specify the VCSEL to be subjected to the lighting control, and the lighting signal φI of "L" (-5 V) turns on the setting thyristor S, which is connected in series to the VCSEL to be subjected to the lighting control, and lights the VCSEL. That is, in the light emitting chip 10, the VCSELs are sequentially lit by transferring the ON state of the transfer thyristors T.

It should be noted that the lighting signal φI of "H" (0 V) maintains the setting thyristor S in the OFF state and maintains the VCSEL which is not lit. That is, the lighting signal φI sets the lighting/non-lighting of the VCSEL.

As described above, in the light source device 1 of the present exemplary embodiment, there are a plurality of elements (transfer thyristors T1 to T12, setting thyristors S1 to S12, VCSEL1 to VCSEL12, and the like). Thus, among the plurality of elements, elements to be in the ON state are sequentially turned on. Thereby, in the light source device 1 in the present exemplary embodiment, the plurality of transfer thyristors T1 to T12 in the transfer unit 30 of the light emitting chip 10 are individually turned ON by the lighting control by the control unit 12. Then, the transfer thyristors T1 to T12 are turned on, so that the VCSEL which is the target of the lighting control is designated, and the setting thyristors S1 to S12 of the plurality of light emitting sections 21-1 to 21-12 in the light emitting unit 20 individually turns into the ON state. Then, each of the setting thyristors S turns into the ON state, so that the VCSELs corresponding to the setting thyristors S are individually lit.

As a result, in the light source device 1 in the present exemplary embodiment, the light emitting sections 21-1 to 21-12 of the light emitting unit 20 can be caused to individually emit light.

(3D Sensor 5)

The 3D sensor 5 includes a light receiving surface that extends in the x direction and the y direction and on which a plurality of light receiving elements are arranged. Although not shown, the light receiving surface of the 3D sensor 5 is divided into a plurality of light receiving sections corresponding to regions irradiated with light emitted from the light emitting sections 21-1 to 21-12 of the light emitting unit 20 formed on the light emitting chip 10. Specifically, the light receiving surface of the 3D sensor 5 is divided into a total of 12 light receiving sections, that is, 6 light receiving sections in the x direction and 2 light receiving sections in the y direction.

Then, each of the light receiving sections receives light that is emitted from the light emitting sections 21-1 to 21-12 and then reflected by a target object, and outputs an electrical signal according to a light receiving result. The 3D sensor 5 calculates distance information regarding a distance to the target object based on the electric signal output from each of the light receiving sections, and outputs the distance information to the measurement control unit 200 (see Fig. 1). Each light receiving section is independently driven to perform a light receiving operation in response to the light emitting operation of the light emitting sections 21-1 to 21-12.

(Action of Transfer Unit 30 Based on Planar Shape)

In the light emitting chip 10 in the present exemplary embodiment, as described above, the transfer unit 30 is separately disposed at two places on the substrate 80.

Here, in a case where the transfer unit 30 is provided at one place on the substrate 80 in the light emitting chip 10 having the plurality of light emitting sections 21, there may be many portions where a distance from the transfer unit 30 to the light emitting section 21 is long. For example, in a case where the light emitting unit 20 has 12 light emitting sections 21-1 to 21-12 as shown in Fig. 3, and in a case where the transfer unit 30 is provided at one place on the +y direction side of the light emitting unit 20, a distance from the transfer unit 30 to the light emitting sections 21-7 to 21-12 is longer than a distance from the transfer unit 30 to the light emitting sections 21-1 to 21-6.

In a case where the distance from the transfer unit 30 to the light emitting section 21 is long, the signal line 41 connecting the transfer unit 30 and each light emitting section 21 is likely to be long.

On the other hand, in the light emitting chip 10 in the present exemplary embodiment, the transfer unit 30 includes the first transfer unit 30A disposed on the +y direction side of the light emitting unit 20 and the second transfer unit 30B disposed on the -y direction side of the light emitting unit 20, on the substrate 80.

As a result, in the light emitting chip 10 in the present exemplary embodiment, an occurrence of a situation in which there are many portions where the distance from the transfer unit 30 to the light emitting section 21 is long is suppressed as compared with a case where the transfer unit 30 is provided at one place on the substrate 80.

The first transfer unit 30A is connected to the light emitting sections 21-1 to 21-6 of the light emitting section group 21A located on the substrate 80 on the +y direction side of the light emitting unit 20. In addition, the second transfer unit 30B is connected to the light emitting sections 21-7 to 21-12 of the light emitting section group 21B located on the substrate 80 on the -y direction side of the light emitting unit 20.

As a result, in the light emitting chip 10 in the present exemplary embodiment, an occurrence of a situation in which the signal line 41 connecting the transfer unit 30 and each light emitting section 21 is long is suppressed as compared with a case where the transfer unit 30 is provided at one place on the substrate 80.

In addition, in order to connect the transfer unit 30 and each light emitting section 21, the signal line 41 does not need to be provided between the light emitting sections 21. In this case, it is possible to simplify the structure of the light emitting chip 10 or the manufacturing process of the light emitting chip 10.

In the light emitting unit 20 described above, two light emitting sections 21 are arranged in the y direction, but the arrangement of the light emitting sections 21 is not limited to this. In the light emitting unit 20, three or more light emitting sections 21 may be arranged in the y direction. Even in a case where three or more light emitting sections 21 are arranged in the y direction, it is sufficient that the light emitting section 21 located on the +y direction side among the plurality of light emitting sections 21 is connected to the first transfer unit 30A, and the light emitting section 21 located on the -y direction side is connected to the second transfer unit 30B, as in the present exemplary embodiment.

In a case where an odd number of the light emitting sections 21 are arranged in the y direction and there is the light emitting section 21 in which the distance from the first transfer unit 30A is equal to the distance from the second transfer unit 30B, this light emitting section 21 may be connected to either the first transfer unit 30A or the second transfer unit 30B. For example, it is sufficient that the number of the light emitting sections 21 connected to the first transfer unit 30A is substantially the same as the number of the light emitting sections 21 connected to the second transfer unit 30B.

In addition, in the light emitting unit 20 described above, the light emitting sections 21 belonging to the same light emitting section group 21A or 21B are disposed to be arranged, but the present exemplary embodiment is not limited to this. The light emitting sections 21 belonging to the same light emitting sections 21A or 21B may be disposed at positions spaced apart from each other on the substrate 80. For example, the light emitting sections 21 belonging to the light emitting section group 21B may be disposed between the light emitting sections 21 belonging to the light emitting section group 21A.

In addition, in the above-described exemplary embodiment, the first transfer unit 30A and the second transfer unit 30B of the transfer unit 30 are connected to each other. Then, the transfer signals φ1 and φ2 common to the first transfer unit 30A and the second transfer unit 30B are supplied by the control unit 12, and the ON state is sequentially transferred to the transfer thyristors T1 to T6 of the first transfer unit 30A and the transfer thyristors T7 to T12 of the second transfer unit 30B.

However, the first transfer unit 30A and the second transfer unit 30B of the transfer unit 30 disposed at the positions spaced apart from each other on the substrate 80 do not need to be connected to each other. It should be noted that the transfer signals may be individually supplied to the first transfer unit 30A and the second transfer unit 30B, and the

EP 4 592 704 A1

ON state may be individually transferred to the transfer thyristors T1 to T6 of the first transfer unit 30A and the transfer thyristors T7 to T12 of the second transfer unit 30B.

On the other hand, from the viewpoint of performing the lighting control of the light emitting sections 21-1 to 21-6 of the light emitting section group 21A connected to the first transfer unit 30A and the light emitting sections 21-7 to 21-12 of the light emitting section group 21B connected to the second transfer unit 30B in conjunction with each other, for example, it is preferable that the first transfer unit 30A and the second transfer unit 30B are connected to each other and the transfer signals φ1 and φ2 common to the first transfer unit 30A and the second transfer unit 30B are supplied. In this case, for example, an occurrence of a situation in which the light emitting sections 21-1 to 21-6 belonging to the light emitting section group 21A and the light emitting sections 21-7 to 21-12 belonging to the light emitting section group 21B unintentionally emit light at the same time is prevented.

[Second Exemplary Embodiment]

Subsequently, a second exemplary embodiment of the present invention will be described.

(Light Emitting Chip 10)

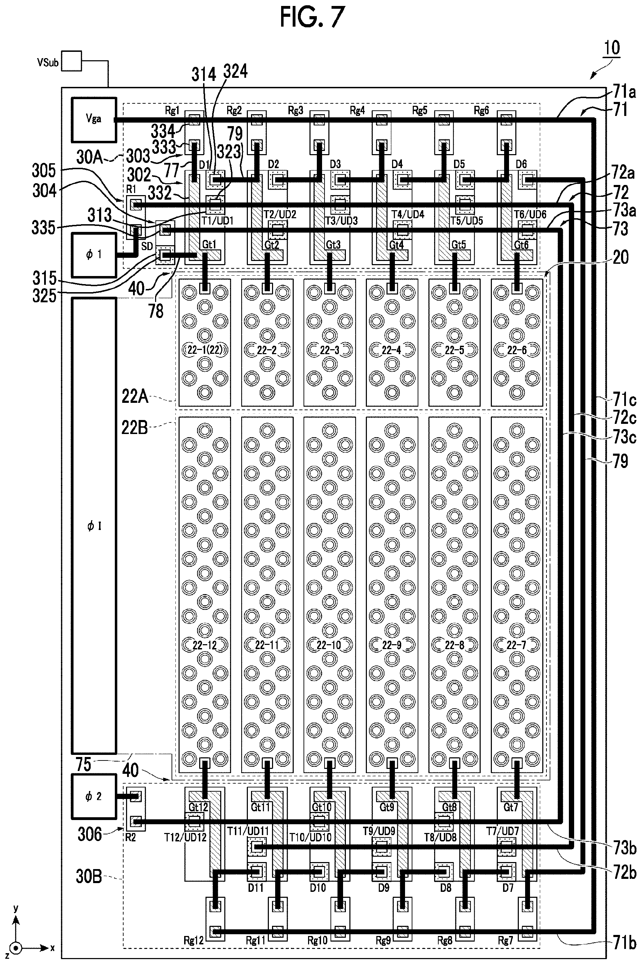

Fig. 7 is a diagram showing a planar shape of a light emitting chip 10 to which the second exemplary embodiment is applied, and is a plan view of the light emitting chip 10 as viewed from a side on which light is emitted. In Fig. 7, a rightward direction of the paper plane is defined as a +x direction, an upward direction of the paper plane is defined as a +y direction, and a front side of the paper plane is defined as a +z direction. Opposite directions of the directions are defined as -x, -y, and -z directions, respectively.

In the second exemplary embodiment, the same configurations as the configurations in the first exemplary embodiment are denoted by the same reference symbols, and the detailed description thereof will be omitted here.

The light emitting chip 10 in the second exemplary embodiment includes a light emitting unit 20, a transfer unit 30 (see Fig. 2), and a connection portion 40, as in the first exemplary embodiment. Further, the light emitting chip 10 includes a φ1 terminal, a φ2 terminal, a Vga terminal, a φI terminal, and a Vsub terminal.

The light emitting unit 20 has a plurality of light emitting sections 22 each of which includes at least one VCSEL. The light emitting unit 20 has a total of 12 light emitting sections 22, that is, 6 light emitting sections 22 in the x direction and 2 light emitting sections 22 in the y direction. Here, in a case where the light emitting sections 22 are distinguished from each other, the 12 light emitting sections 22 are referred to as the light emitting sections 22-1 to 22-12.

The six light emitting sections 22-1 to 22-6 are disposed to be arranged in this order from the -x direction side to the +x direction side in the light emitting unit 20. Such light emitting sections 22-1 to 22-6 may be collectively referred to as a light emitting section group 22A below. In the present exemplary embodiment, the light emitting sections 22-1 to 22-6 are examples of first light emitting sections, and the light emitting section group 22A is an example of a first light emitting section group.

In addition, the six light emitting sections 22-7 to 22-12 are disposed to be arranged in this order from the +x direction side to the -x direction side in the light emitting unit 20. Such light emitting sections 22-7 to 22-12 may be collectively referred to as a light emitting section group 22B below. In the present exemplary embodiment, the light emitting sections 22-7 to 22-12 are examples of second light emitting sections, and the light emitting section group 22B is an example of a second light emitting section group.

The light emitting section group 22A and the light emitting section group 22B are disposed to be arranged in this order from the +y direction side to the -y direction side. It should be noted that the light emitting sections 22-1, 22-2, 22-3, 22-4, 22-5, and 22-6 belonging to the light emitting section group 22A are disposed to be arranged in the +y direction with respect to the light emitting sections 22-12, 22-11, 22-10, 22-9, 22-8, and 22-7 belonging to the light emitting section group 22B, respectively.

In addition, the light emitting unit 20 includes 12 setting thyristors S1 to S12 as in the first exemplary embodiment. Each of the setting thyristors S is connected in series with the VCSEL of the light emitting section 22 to which the same number is assigned. It should be noted that the setting thyristors S1 to S12 are stacked on the VCSEL1 to VCSEL12 of the respective light emitting sections 22-1 to 22-12 having the same number. That is, each of the light emitting sections 22 includes the setting thyristor S and the VCSEL.

In the light emitting unit 20 in the second exemplary embodiment, the planar shapes of the light emitting sections 22-1 to 22-6 belonging to the light emitting section group 22A are different from the planar shapes of the light emitting sections 22-7 to 22-12 belonging to the light emitting section group 22B.

Specifically, in the light emitting unit 20 in the present exemplary embodiment, the areas of the light emitting sections 22-1 to 22-6 belonging to the light emitting section group 22A as viewed from the +z direction side are smaller than the areas of the light emitting sections 22-7 to 22-12 belonging to the light emitting section group 22B as viewed from the +z direction side. In the light emitting unit 20, in a case where the same amount of power is supplied to the light emitting

19

sections 22-1 to 22-12, the intensity of light emitted from the light emitting sections 22-1 to 22-6 belonging to the light emitting section group 22A is smaller than the intensity of light emitted from the light emitting sections 22-7 to 22-12 belonging to the light emitting section group 22B.

In addition, the transfer unit 30 is driven to sequentially transfer the ON state, and switches each of the light emitting sections 22-1 to 22-12 of the light emitting unit 20 between a light emitting state and a non-light emitting state.

The transfer unit 30 includes transfer thyristors T1 to T12, lower diodes UD1 to UD12, coupling diodes D1 to D11, power source line resistors Rg1 to Rg12, a start diode SD, and current limiting resistors R1 and R2, which are provided on a substrate 80, as in the first exemplary embodiment.

In the light emitting chip 10 in the second exemplary embodiment, as in the first exemplary embodiment, the first transfer unit 30A consisting of the transfer thyristors T1 to T6, the lower diodes UD1 to UD6, the coupling diodes D1 to D6, the power source line resistors Rg1 to Rg6, the start diode SD, and the current limiting resistor R1, and the second transfer unit 30B consisting of the transfer thyristors T7 to T12, the lower diodes UD7 to UD12, the coupling diodes D7 to D11, the power source line resistors Rg7 to Rg12, and the current limiting resistor R2 in the transfer unit 30 are separately disposed at positions facing each other with the light emitting unit 20 interposed between the first transfer unit 30A and the second transfer unit 30B.

(Optical System 11)

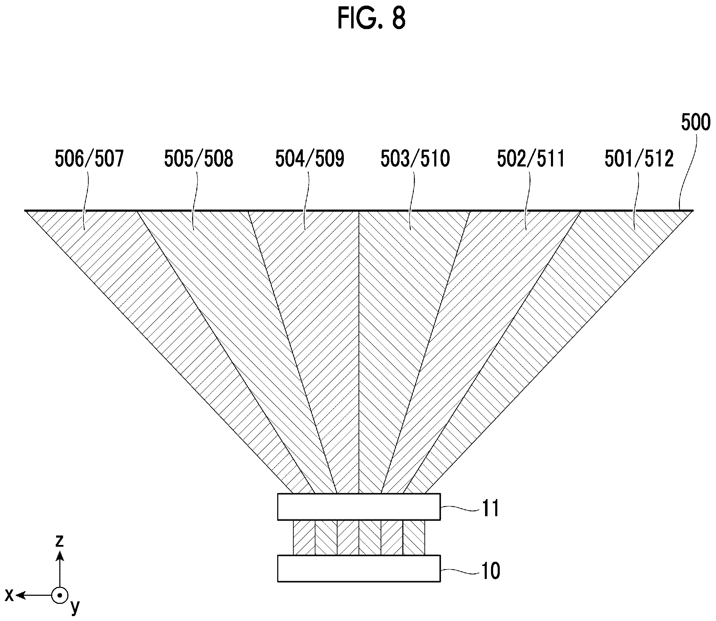

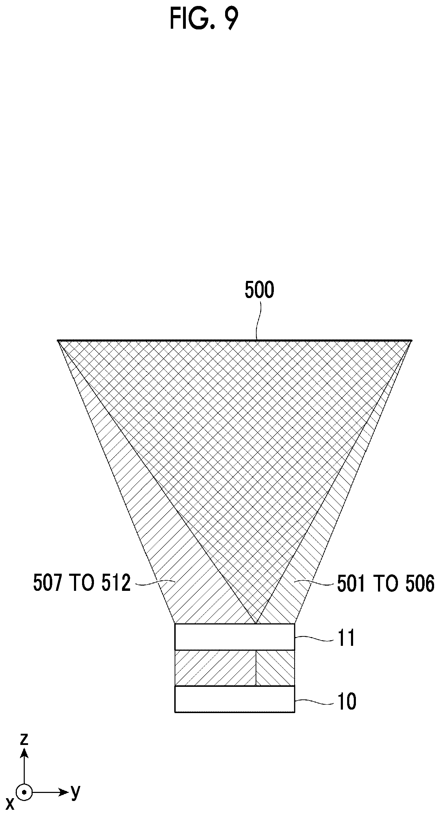

Fig. 8 and Fig. 9 are diagrams illustrating a relationship between the light emitting chip 10 and the optical system 11 in the present exemplary embodiment. In Fig. 8, a leftward direction of the paper plane is defined as a +x direction, a front side of the paper plane is defined as a +y direction, and an upward direction of the paper plane is defined as a +z direction. Opposite directions of the directions are defined as -x, -y, and -z directions, respectively. In addition, in Fig. 9, a front side of the paper is defined as the +x direction, a rightward direction is defined as the +y direction, and the upward direction is defined as the +z direction. The opposite directions are defined as the -x, -y, and -z directions.

In Fig. 8 and Fig. 9, irradiation ranges of light emitted from the light emitting sections 22-1 to 22-12 (see Fig. 7) are indicated by the reference symbols 501 to 512, respectively. The irradiation ranges of the light emitted from the light emitting sections 22-1 to 22-12 may be referred to as irradiation ranges 501 to 512, respectively.

In Fig. 8, the irradiation range 501/512 means that the irradiation range 501 overlaps the irradiation range 512 in a case of being viewed from the +y direction side. The same applies to the irradiation ranges 502 to 511. In addition, in Fig. 9, the irradiation ranges 501 to 506 mean that the irradiation ranges 501, 502, 503, 504, 505, and 506 overlap each other in a case of being viewed from the +x direction side. The same applies to the irradiation ranges 507 to 512.

Fig. 8 and Fig. 9 show an irradiation surface 500 that is perpendicular to the +z direction and is irradiated with light in the irradiation ranges 501 to 512 at a certain distance in the +z direction which is a direction in which the light emitting unit 20 of the light emitting chip 10 emits light. The irradiation surface 500 extends in the x direction and the y direction at a certain distance in the +z direction.

As shown in Fig. 8 and Fig. 9, the optical system 11 is disposed on the +z direction side with respect to the light emitting chip 10. In addition, the optical system 11 expands the irradiation range of the light emitted from each light emitting section 22 (see Fig. 7) of the light emitting unit 20 in the light emitting chip 10 as the light goes in the +z direction.

In the optical system 11, the degree of expansion of the irradiation range of the light emitted from each light emitting section 22 of the light emitting unit 20 is different between the x direction and the y direction. The degree of expanding the irradiation range of light by the optical system 11 is referred to as a diffusion degree of light by the optical system 11.

In the present exemplary embodiment, in the optical system 11, a diffusion degree of light emitted from each light emitting section 22 of the light emitting unit 20 in the x direction is larger than a diffusion degree in the y direction.

In addition, for example, it is preferable that the optical system 11 diffuses light from each light emitting section 22 such that the irradiation range of light of one light emitting section 22 belonging to the light emitting section group 22A overlaps the irradiation range of light of other light emitting sections 22 that are arranged in the -y direction with respect to the one light emitting section 22 and belong to the light emitting section group 22B, on the irradiation surface 500.

Since the irradiation range of light of one light emitting section 22 belonging to the light emission region group 22A overlaps the irradiation range of light of the other light emitting sections 22 that are arranged in the -y direction with respect to the one light-emitting region 22 and belong to the light emitting section group 22B, it is possible to irradiate the same region with light from the one light emitting section 22 and the other light emitting sections 22 on the irradiation surface 500. In this case, depending on the size of a target object on the irradiation surface 500, there is a high possibility that the same target object can be irradiated with light by one light emitting section 22 and the other light emitting sections 22.

It should be noted that, for example, it is preferable that the optical system 11 diffuses light from each light emitting section 22 such that the overlap between the irradiation range of the light of one light emitting section 22 belonging to the light emitting section group 22A and the irradiation range of the light of the other light emitting sections 22 which are arranged in the -y direction with respect to the one light emitting section 22 and belong to the light emitting section group 22B is larger than the overlap between the irradiation ranges of the light of the light emitting sections 22 arranged in the x direction in the light emitting section group 22A and the overlap between the irradiation ranges of the light of the light emitting sections 22 arranged in the x direction in the light emitting section group 22B.

In this case, for example, it is preferable that the optical system 11 does not have an optical action in the y direction and has an optical action in the x direction with respect to the light emitted from each light emitting section 22 of the light emitting unit 20.

It should be noted that, in the present exemplary embodiment, for example, in a case where the light emitting section 22-1 of the light emitting section group 22A is used as one light emitting section 22, the light emitting sections 22-12 arranged in the -y direction with respect to the light emitting section 22-1 correspond to the other light emitting sections 22 of the light emitting section group 22B.

In the following description, the other light emitting sections 22 arranged in the -y direction with respect to one light emitting section 22 belonging to the light emitting section group 22B may be referred to as the other light emitting sections 22 belonging to the light emitting section group 22B.

Here, in a case where the optical system 11 does not optically act in the y direction, the light from each light emitting section 22 is spread in accordance with the original property, and in the irradiation surface 500 which is 100 mm away from the optical system 11 in the +z direction, the overlap between the illuminance distribution of the light emitted from one light emitting section 22 belonging to the light emitting section group 22A, in the y direction, and the illuminance distribution of the light emitted from the other light emitting section 22 belonging to the light emitting section group 22B, in the y direction, is equal to or more than 80%.

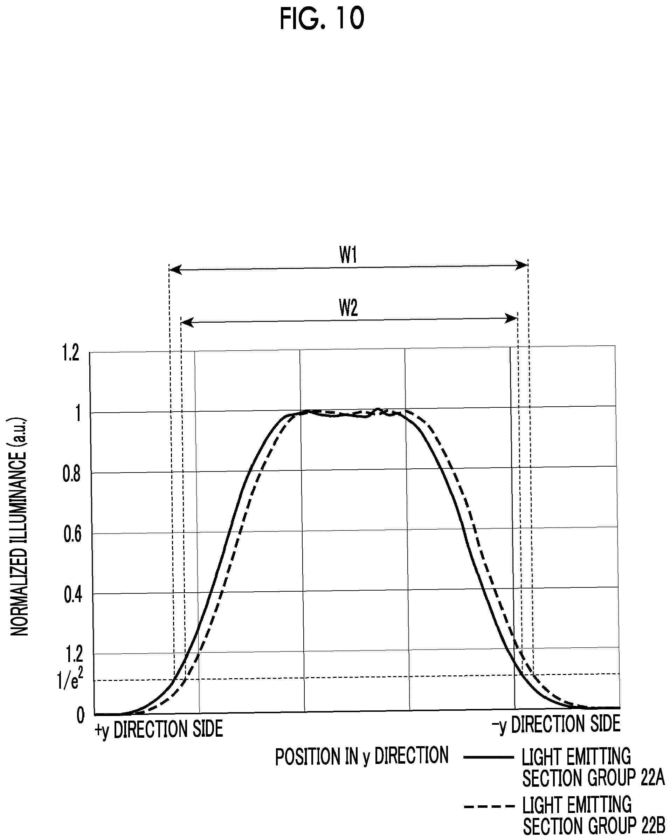

Fig. 10 is a diagram showing an example of the illuminance distribution of one light emitting section 22 belonging to the light emitting section group 22A and the illuminance distribution of the other light emitting section 22 belonging to the light emitting section group 22B.

In Fig. 10, the horizontal axis represents a position in the y direction on the irradiation surface 500, and the vertical axis represents the normalized illuminance (normalized illuminance).

The illuminance distribution of one light emitting section 22 belonging to the light emitting section group 22A and the illuminance distribution of the other light emitting section 22 belonging to the light emitting section group 22B are normalized such that the peak intensity having the maximum value of illuminance is 1. In addition, in the illuminance distribution of one light emitting section 22 belonging to the light emitting section group 22A and the illuminance distribution of the other light emitting sections 22 belonging to the light emitting section group 22B, a width of a region in the y direction in which the illuminance is equal to or greater than $1/e^2$ of the peak intensity is defined as an irradiation width W1. Further, a width of a region in the y direction in which a region in which the illuminance is equal to or greater than $1/e^2$ of the peak intensity in the illuminance distribution of one light emitting section 22 belonging to the light emitting section group 22A overlaps a region in which the illuminance is equal to or greater than $1/e^2$ of the peak intensity in the illuminance distribution of the other light emitting sections 22 belonging to the light emitting section group 22B is defined as an overlap width W2.

In this case, the overlap between the illuminance distribution of one light emitting section 22 of the light emitting section group 22A and the illuminance distribution of the other light emitting sections 22 of the light emitting section group 22B can be obtained by Expression (1).

$$\text{(overlap width W2/irradiation width W1)} \times 100 \ (\%) \ ... \ (1)$$

The optical system 11 used in the present exemplary embodiment may be, for example, a single optical member that collectively diffuses light emitted from a plurality of light emitting sections 22 of the light emitting unit 20, or may be a plurality of optical members that are individually provided for each light emitting section 22 and diffuse light emitted from the individual light emitting sections 22.

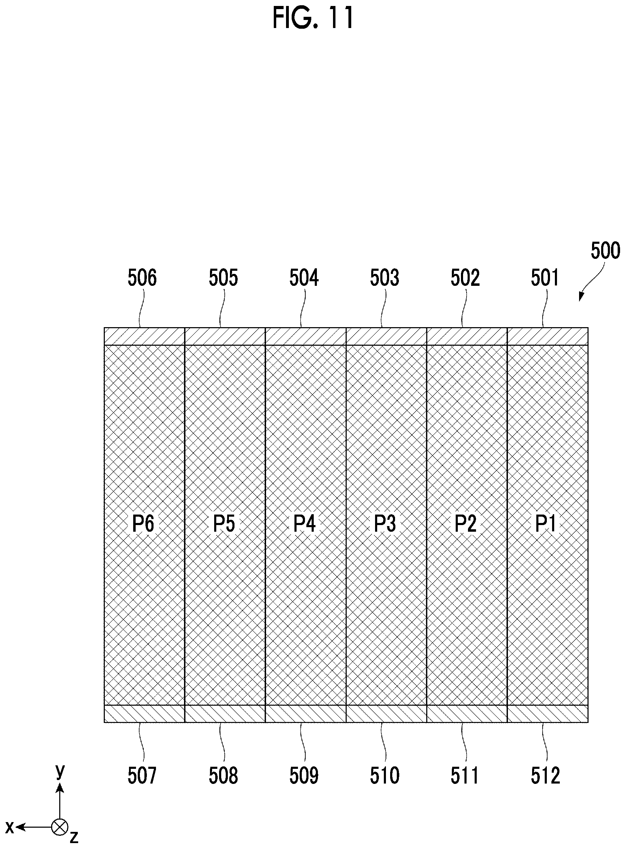

Fig. 11 is a diagram showing an example of the irradiation surface 500 irradiated with light emitted from the light emitting sections 22-1 to 22-12 of the light emitting unit 20. In Fig. 11, a leftward direction of the paper plane is defined as a +x direction, an upward direction of the paper plane is defined as a +y direction, and a rear side of the paper plane is defined as a +z direction. Opposite directions of the directions are defined as -x, -y, and -z directions, respectively.

In the irradiation surface 500, the light emitted from the light emitting sections 22-1 to 22-12 of the light emitting unit 20 is diffused by the optical system 11 described above, so that the irradiation range of the light from one light emitting section 22 belonging to the light emitting section group 22A overlaps the irradiation range of the light from the other light emitting sections 22 belonging to the light emitting section group 22B.

Specifically, in the irradiation surface 500, the irradiation range 501 of light by the light emitting section 22-1 overlaps the irradiation range 512 by the light emitting section 22-12 arranged in the -y direction with respect to the light emitting section 22-1. Similarly, in the irradiation surface 500, the irradiation range 502 of light by the light emitting section 22-2 overlaps the irradiation range 511 by the light emitting section 22-11 arranged in the -y direction with respect to the light emitting section 22-2. In addition, in the irradiation surface 500, the irradiation range 503 of light by the light emitting section 22-3 overlaps the irradiation range 510 by the light emitting section 22-10 arranged in the -y direction with respect to the light emitting section 22-3. In addition, in the irradiation surface 500, the irradiation range 504 of light by the light emitting section 22-4 overlaps the irradiation range 509 by the light emitting section 22-9 arranged in the -y direction with respect to the light emitting section 22-4. In addition, in the irradiation surface 500, the irradiation range 505 of light by the light emitting section 22-5 overlaps the irradiation range 508 by the light emitting section 22-8 arranged in the -y direction with respect to the light emitting section 22-5. In addition, in the irradiation surface 500, the irradiation range 506 of light by the light emitting section 22-6 overlaps the irradiation range 507 by the light emitting section 22-7 arranged in the -y direction with respect to the light emitting section 22-6.

As a result, the irradiation surface 500 is divided into six irradiation sections P1 to P6 arranged in the -x direction to the +x direction. The irradiation section P1 is a region irradiated with light by the light emitting section 22-1 and light by the light emitting section 22-12. The irradiation section P2 is a region irradiated with light by the light emitting section 22-2 and light by the light emitting section 22-11. The irradiation section P3 is a region irradiated with light by the light emitting section 22-3 and light by the light emitting section 22-10. The irradiation section P4 is a region irradiated with light by the light emitting section 22-4 and light by the light emitting section 22-9. The irradiation section P5 is a region irradiated with light by the light emitting section 22-5 and light by the light emitting section 22-8. The irradiation section P6 is a region irradiated with light by the light emitting section 22-6 and light by the light emitting section 22-7.

(3D Sensor 5)

A 3D sensor 5 (see Fig. 1) used in the second exemplary embodiment includes a light receiving surface that extends in the x direction and the y direction and in which a plurality of light receiving elements are arranged, as in the first exemplary embodiment. Although not shown, the light receiving surface of the 3D sensor 5 is divided into a plurality of light receiving sections corresponding to the irradiation sections P1 to P6 of the irradiation surface 500. Specifically, the light receiving surface of the 3D sensor 5 is divided into 6 light receiving sections arranged in the x direction.

Then, each of the light receiving sections receives light that is emitted from the light emitting sections 22-1 to 22-12 and then reflected by the target object in the irradiation sections P1 to P6. Each light receiving section is independently driven to perform a light receiving operation in response to the light emitting operation of the light emitting sections 22-1 to 22-12.

(Operation of Light Emitting Chip 10)

Subsequently, an operation of the light emitting chip 10 will be described.

In a light source device 1 (see Fig. 1) to which the second exemplary embodiment is applied, as in the first exemplary embodiment, there are a plurality of elements (transfer thyristors T1 to T12, setting thyristors S1 to S12, VCSEL1 to VCSEL12, and the like), and the elements to be in the ON state among the plurality of elements are sequentially transitioned. As a result, in the light source device 1, the plurality of transfer thyristors T1 to T12 in the transfer unit 30 of the light emitting chip 10 are individually turned ON by the lighting control by the control unit 12. Then, the transfer thyristors T1 to T12 are turned on, so that the VCSEL which is the target of the lighting control is designated, and the setting thyristors S 1 to S12 of the plurality of light emitting sections 22-1 to 22-12 in the light emitting unit 20 individually turns into the ON state. Then, each of the setting thyristors S turns into the ON state, so that the VCSELs corresponding to the setting thyristors S are individually lit.

As a result, in the light source device 1 in the present exemplary embodiment, the light emitting sections 22-1 to 22-12 of the light emitting unit 20 can be caused to individually emit light.

In the light source device 1 in the present exemplary embodiment, the control unit 12 performs the lighting control of the light emitting unit 20 such that one of one light emitting section 22 belonging to the light emitting section group 22A that irradiates, with light, each of the irradiation section P1 to P6 of the irradiation surface 500 and the other light emitting sections 22 that are arranged in the -y direction with respect to the one light emitting section 22 and belong to the light emitting section group 22B is in the lighting state, the other is in the non-lighting state. It should be noted that, the light source device 1 in the present exemplary embodiment performs the lighting control of the light emitting unit 20 such that, in a period in which the ON state is transitioned from the transfer thyristor T1 of the transfer unit 30 to the transfer thyristor T12, one of one light emitting section 22 belonging to the light emitting section group 22A that irradiates, with light, each of the irradiation sections P1 to P6 and the other light emitting sections 22 belonging to the light emitting section group 22B is in the lighting state, and the other is in the non-lighting state.

For example, the control unit 12 performs the lighting control such that one of the light emitting section 22-1 belonging to the light emitting section group 22A that irradiates, with light, the irradiation section P1 of the irradiation surface 500 and the light emitting section 22-12 that is arranged in the -y direction with respect to the light emitting section 22-1 and belongs to the light emitting section group 22B is in the lighting state and the other is in the non-lighting state.

Here, in a case where the light emitting section 22 is in the lighting state, the temperature of the light emitting section 22 increases due to heat generation accompanying the light emission of the VCSEL. In a case where the temperature of the light emitting section 22 increases, an influence such as a decrease in light output of the VCSEL may occur. The increase in the temperature of the light emitting section 22 due to the heat generation of the VCSEL may affect not only the light emitting section 22 in the lighting state but also the light emitting section 22 adjacent to the light emitting section 22 in the lighted state.

In a case where the lighting control of the light emitting unit 20 is performed such that both one light emitting section 22 belonging to the light emitting section group 22A and the other light emitting section 22 that is arranged in the -y direction with respect to the one light emitting section 22 and belongs to the light emitting section group 22B turn into the lighting state, the temperature increase occurs in the one light emitting section 22 and the other light emitting section 22, and the influence such as a decrease in the intensity of light of the VCSEL is more likely to occur.

On the other hand, in the present exemplary embodiment, by performing the lighting control such that one of the one light emitting sections 22 belonging to the light emitting section group 22A and the other light emitting section 22 belonging to the light emitting section group 22B is in the lighting state and the other is in the non-lighting state, it is possible to suppress the influence of the temperature increase of the light emitting section 22.

As described above, the intensity of light emitted from the light emitting sections 22-1 to 22-6 belonging to the light emitting section group 22A is smaller than the intensity of light emitted from the light emitting sections 22-7 to 22-12 belonging to the light emitting section group 22B.

In the present exemplary embodiment, for each of the irradiation sections P1 to P6, either of the one light emitting sections 22 belonging to the light emitting section group 22A or the other light emitting section 22 belonging to the light emitting section group 22B is set in the lighting state, and the other is set in the non-lighting state, so that it is possible to select the magnitude of the intensity of light with which each of the irradiation sections P1 to P6 is irradiated. It should be noted that, in a case where one light emitting section 22 belonging to the light emitting section group 22A is set in the lighted state and the other light emitting section 22 belonging to the light emitting section group 22B is set in the non-lighting state, the intensity of light with which the corresponding irradiation section P1 to P6 are irradiated is smaller than the intensity of light in a case where one light emitting section 22 belonging to the light emitting section group 22A is set in the non-lighting state and the other light emitting section 22 belonging to the light emitting section group 22B is set in the lighting state.

The control unit 12 can determine which of the one light emitting section 22 belonging to the light emitting section group 22A and the other light emitting section 22 belonging to the light emitting section group 22B is set in the lighted state, for example, according to the distance from the light source device 1 to the target object in each of the irradiation sections P1 to P6.

In a case where the distance from the light source device 1 to the target object is short, in a case where the intensity of light emitted to the target object is large, the intensity of light that is reflected by the target object and then incident on the corresponding light receiving section of the 3D sensor 5 is likely to be large. In this case, the signal may be saturated in the light receiving section, and the distance to the target object may not be able to be accurately measured.

The control unit 12 acquires the distance information from the light source device 1 to the target object in each of the irradiation sections P1 to P6 calculated from the light reception result by the 3D sensor 5. Then, the control unit 12 determines whether or not the distance from the light source device 1 to the target object in each of the irradiation sections P1 to P6 is closer than a predetermined distance.

In addition, regarding the irradiation sections P1 to P6 in which the distance from the light source device 1 to the target object is shorter than the predetermined distance, the control unit 12 sets one light emitting section 22 belonging to the light emitting section group 22A into the lighting state and sets the other light emitting sections 22 belonging to the light emitting section group 22B into the non-lighting state. In addition, for the irradiation sections P1 to P6 in which the distance from the light source device 1 to the target object is equal to or greater than the predetermined distance, the control unit 12 sets one light emitting section 22 belonging to the light emitting section group 22A into the non-lighting state and sets the other light emitting section 22 belonging to the light emitting section group 22B into the lighting state.

As a result, the signal is less likely to be saturated in the light receiving section of the 3D sensor 5.

In addition, the control unit 12 may determine which of the one light emitting section 22 belonging to the light emitting section group 22A or the other light emitting section 22 belonging to the light emitting section group 22B is set into the lighted state, for example, according to the intensity of received light of the light receiving section in the 3D sensor 5.

It should be noted that, in a case where the intensity of received light in the light receiving section exceeds a predetermined threshold value, regarding the irradiation sections P1 to P6 corresponding to the light receiving section, the control unit 12 sets one light emitting section 22 belonging to the light emitting section group 22A into the lighting state and sets the other light emitting sections 22 belonging to the light emitting section group 22B into the non-lighting state. In addition, in a case where the intensity of received light of the light receiving section is equal to or less than the predetermined threshold value, regarding the irradiation sections P1 to P6 corresponding to the light receiving section, the control unit 12 sets one light emitting section 22 belonging to the light emitting section group 22A into the non-lighting state and sets the other light emitting sections 22 belonging to the light emitting section group 22B into the lighting state. As the threshold value of the intensity of received light, for example, a light receiving amount at which the signal is saturated in the light receiving section can be used.

As a result, the signal is less likely to be saturated in the light receiving section of the 3D sensor 5.

Here, in the above-described exemplary embodiment, a case in which the intensity of light emitted from the light emitting section 22 belonging to the light emitting section group 22A is different from the intensity of light emitted from the light emitting section 22 belonging to the light emitting section group 22B has been described as an example, but the present exemplary embodiment is not limited to this. The intensity of light emitted from the light emitting section 22 belonging to the light emitting section group 22A may be equal to the intensity of light emitted from the light emitting section 22 belonging to the light emitting section group 22B.

Even in such a case, in the present exemplary embodiment, by performing the lighting control such that one of the one light emitting sections 22 belonging to the light emitting section group 22A and the other light emitting section 22 belonging to the light emitting section group 22B is in the lighting state and the other is in the non-lighting state, it is possible to suppress the influence of the temperature increase of the light emitting section 22.

In a case where the intensity of light emitted from the light emitting section 22 belonging to the light emitting section group 22A is equal to the intensity of light emitted from the light emitting section 22 belonging to the light emitting section group 22B, the control unit 12 can select which of the one light-emitting region 22 belonging to the light-emitting region group 22A or the other light-emitting region 22 belonging to the light-emitting region group 22B is set into the lighting state so that the influence of the temperature increase of the light emitting section 22 is reduced.

For example, a case in which, among the light emitting section 22-1 and the light emitting section 22-12 that irradiate the irradiation section P1 with light, the light emitting section 22-1 is set into the lighting state, and the light emitting section 22-12 is set into the non-lighting state is considered. In this case, it is sufficient that, among the light emitting section 22-2 and the light emitting section 22-11 that irradiate, with light, the irradiation section P2 adjacent to the irradiation section P1, the control unit 12 sets, into the lighting state, the light emitting section 22-2 having a large influence of the temperature increase due to setting of the light emitting section 22-1 arranged in the +x direction with respect to the light emitting section 22-1 into the lighting state is set into the non-lighting state, and the light emitting section 22-11 having a small influence of the temperature increase due to setting of the light emitting section 22-1 into the lighting state is set into the lighting state.

Although the exemplary embodiments of the present invention have been described above, the technical scope of the present invention is not limited to the above exemplary embodiment.

Various changes and substitutions of configurations that do not depart from the scope of the technical idea of the present disclosure are included in the present disclosure.

(Supplementary Notes)

(((1))) A light emitting device comprising:

a substrate;
a light emitting unit that is provided on the substrate and has a plurality of light emitting sections;
a first switching unit that is provided on the substrate and switches a first light emitting section of the light emitting unit between a light emitting state and a non-light emitting state; and
a second switching unit that is provided on the substrate on an opposite side of the first switching unit with the light emitting unit interposed between the first switching unit and the second switching unit, switches a second light emitting section different from the first light emitting section of the light emitting unit, between the light emitting state and the non-light emitting state.

(((2))) The light emitting device according to (((1))),
wherein the first switching unit and the second switching unit are connected by a wiring, and the first light emitting section and the second light emitting section of the light emitting unit are sequentially switched to the light emitting state and the non-light emitting state by a signal transmitted through the wiring.

(((3))) The light emitting device according to (((2))),

wherein the substrate has a rectangular shape including two first sides facing each other and two second sides that connect the first sides and face each other, and
the first switching unit is provided along one of the first sides, the second switching unit is provided along the other of the first sides, and the wiring is provided along one of the second sides.

(((4))) The light emitting device according to (((3))), further comprising:
a terminal that is provided along the other of the second sides of the substrate and receives a supply of power to the light emitting unit.

(((5))) The light emitting device according to any one of (((2))) to (((4))),
wherein an electrical resistance between the first switching unit and the first light emitting section, and an electrical resistance between the second switching unit and the second light emitting section are larger than an electrical resistance of the wiring.

(((6))) The light emitting device according to any one of (((1))) to (((5))),

wherein, in the light emitting unit, the plurality of light emitting sections are two-dimensionally arranged by being arranged in a first direction and a second direction intersecting the first direction, and the number of the light emitting sections arranged in the first direction is larger than the number of the light emitting sections arranged in the second direction, and

the first switching unit and the second switching unit are disposed along the first direction.

(((7))) The light emitting device according to (((6))),

wherein first light emitting sections are arranged in the first direction,

second light emitting sections are arranged in the second direction with respect to the respective first light emitting sections,

a region irradiated with light by one light emitting section in the first light emitting section overlaps a region irradiated with light by another light emitting section that is arranged in the second direction with respect to the one light emitting section in the second light emitting section, and

the first switching unit and the second switching unit select any of the one light emitting section or the other light emitting section and switch the selected light emitting section to the light emitting state.

(((8))) The light emitting device according to (((7))),
wherein the first light emitting section and the second light emitting section have different intensities of emitted light.

(((9))) The light emitting device according to (((7))), further comprising:

an optical system that guides light emitted from each of the first light emitting section and the second light emitting section such that there is a portion in which the region irradiated with light by the one light emitting section of the first light emitting section overlaps the region irradiated with light by the other light emitting section of the second light emitting section,

wherein, in the optical system, a diffusion degree of the light emitted from each of the light emitting sections in the first direction is larger than a diffusion degree of the light in the second direction.

(((10))) The light emitting device according to (((7))), further comprising:

an optical system that guides light emitted from each of the first light emitting section and the second light emitting section such that there is a portion in which the region irradiated with light by the one light emitting section of the first light emitting section overlaps the region irradiated with light by the other light emitting section of the second light emitting section,

wherein the optical system does not optically act in the second direction, but optically acts in the first direction.

(((11))) A measurement apparatus comprising:

the light emitting device according to any one of (((1))) to (((10))); and
an acquisition unit that receives reflected light from a measurement target irradiated with light emitted from the light emitting device, and acquires information regarding the measurement target.

(((12))) A light emitting device comprising:

a substrate;
a light emitting unit that is provided on the substrate and has a plurality of light emitting sections, in which the plurality of light emitting sections are two-dimensionally arranged by being arranged in a first direction and a second direction intersecting the first direction, and the number of the light emitting sections arranged in the first direction is larger than the number of the light emitting sections arranged in the second direction; and
an optical system that guides light emitted from the light emitting section,
wherein, in the optical system, a diffusion degree of the light emitted from each of the light emitting sections in the first direction is larger than a diffusion degree of the light emitted in the second direction.

(((13))) A light emitting device comprising:

a substrate;
a light emitting unit that is provided on the substrate and has a plurality of light emitting sections, in which the plurality of light emitting sections are two-dimensionally arranged by being arranged in a first direction and a second direction intersecting the first direction, and the number of the light emitting sections arranged in the first direction is larger than the number of the light emitting sections arranged in the second direction; and
an optical system that guides light emitted from the light emitting section,
wherein the optical system does not optically act in the second direction, but optically acts in the first direction.

(((14))) A light emitting device comprising:

a substrate;
a light emitting unit that is provided on the substrate and has a plurality of light emitting sections, in which the plurality of light emitting sections are two-dimensionally arranged by being arranged in a first direction and a second direction intersecting the first direction, and the number of the light emitting sections arranged in the first direction is larger than the number of the light emitting sections arranged in the second direction; and
an optical system that guides light emitted from the light emitting section,
wherein the optical system acts such that a region irradiated with light from one light emitting section among the plurality of light emitting sections overlaps a region irradiated with light from another light emitting section arranged in the second direction with respect to the one light emitting section.

With the light emitting device according to (((1))), it is possible to shorten the distance from the switching unit to each light emitting section as compared with a case where the switching unit that switches the plurality of light emitting sections between the light emitting state and the non-light emitting state is provided at one place on the substrate.

With the light emitting device according to (((2))), it is possible to suppress an occurrence of a situation in which the light emitting section connected to the first switching unit and the light emitting section connected to the second switching unit unintentionally emit light, as compared with a case where the first switching unit and the second switching unit are connected.

With the light emitting device according to (((3))), it is possible to suppress complication of the wiring as compared with a case in which the wiring is not provided along the second side but is provided on the rear surface or the like.

With the light emitting device according to (((4))), it is possible to suppress an increase in size of the device in a direction along the first side as compared with a case in which the terminal is not provided along the other of the second sides.

With the light emitting device according to (((5))), it is possible to shorten a distance between the first switching unit and the second switching unit having a large electrical resistance, and the light emitting section as compared with a case the switching unit is provided at one place on the substrate.

With the light emitting device according to (((6))), it is possible to shorten a distance between each of the light emitting sections, and the first switching unit or the second switching unit as compared with a case where the first switching unit and the second switching unit are disposed along the second direction.

With the light emitting device according to (((7))), it is possible to irradiate the same region with light by one light emitting section and the other light emitting section.

With the light emitting device according to (((8))), it is possible to perform irradiation by selecting an intensity of light for each region arranged in the first direction.

With the light emitting device according to (((9))), it is possible to irradiate a similar region in the second direction with light as compared with a case where the diffusion degree in the first direction is identical to the diffusion degree in the second direction in the optical system.

With the light emitting device according to (((10))), the light is stable as compared with a case where the optical system acts in the second direction.

With the measurement apparatus according to (((11))), it is possible to shorten the distance from the switching unit to each light emitting section as compared with a case where the switching unit that switches the plurality of light emitting sections between the light emitting state and the non-light emitting state is provided at one place on the substrate.

With the light emitting device according to (((12))), it is possible to irradiate a similar region in the second direction with light as compared with a case where the diffusion degree in the first direction is identical to the diffusion degree in the second direction in the optical system.

With the light emitting device according to (((13))), the light is stable as compared with a case where the optical system acts in the second direction.

With the light emitting device according to (((14))), it is possible to irradiate the same region with light by one light emitting section and the other light emitting section.

The foregoing description of the exemplary embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.

Brief Description of the Reference Symbols

1: light source device
5: 3D sensor
10: light emitting chip
11: optical system
12: control unit
20: light emitting unit
21, 22: light emitting section
30: transfer unit
30A: first transfer unit
30B: second transfer unit
40: connection portion
41: signal line
80: substrate
100: measurement apparatus
200: measurement control unit
S: setting thyristor
T: transfer thyristor
VCSEL: vertical cavity surface emitting laser

**Claims**

1. A light emitting device comprising:

   a substrate;
   a light emitting unit that is provided on the substrate and has a plurality of light emitting sections;
   a first switching unit that is provided on the substrate and switches a first light emitting section of the light emitting unit between a light emitting state and a non-light emitting state; and
   a second switching unit that is provided on the substrate on an opposite side of the first switching unit with the light emitting unit interposed between the first switching unit and the second switching unit, switches a second light emitting section different from the first light emitting section of the light emitting unit, between the light emitting state and the non-light emitting state.

2. The light emitting device according to claim 1,
   wherein the first switching unit and the second switching unit are connected by a wiring, and the first light emitting section and the second light emitting section of the light emitting unit are sequentially switched to the light emitting state and the non-light emitting state by a signal transmitted through the wiring.

3. The light emitting device according to claim 2,

   wherein the substrate has a rectangular shape including two first sides facing each other and two second sides that connect the first sides and face each other, and
   the first switching unit is provided along one of the first sides, the second switching unit is provided along the other of the first sides, and the wiring is provided along one of the second sides.

4. The light emitting device according to claim 3, further comprising:
a terminal that is provided along the other of the second sides of the substrate and receives a supply of power to the light emitting unit.

5. The light emitting device according to any one of claims 2 to 4,
wherein an electrical resistance between the first switching unit and the first light emitting section, and an electrical resistance between the second switching unit and the second light emitting section are larger than an electrical resistance of the wiring.

6. The light emitting device according to any one of claims 1 to 5,

wherein, in the light emitting unit, the plurality of light emitting sections are two-dimensionally arranged by being arranged in a first direction and a second direction intersecting the first direction, and the number of the light emitting sections arranged in the first direction is larger than the number of the light emitting sections arranged in the second direction, and
the first switching unit and the second switching unit are disposed along the first direction.

7. The light emitting device according to claim 6,

wherein first light emitting sections are arranged in the first direction,
second light emitting sections are arranged in the second direction with respect to the respective first light emitting sections,
a region irradiated with light by one light emitting section in the first light emitting section overlaps a region irradiated with light by another light emitting section that is arranged in the second direction with respect to the one light emitting section in the second light emitting section, and
the first switching unit and the second switching unit select any of the one light emitting section or the other light emitting section and switch the selected light emitting section to the light emitting state.

8. The light emitting device according to claim 7,
wherein the first light emitting section and the second light emitting section have different intensities of emitted light.

9. The light emitting device according to claim 7, further comprising:

an optical system that guides light emitted from each of the first light emitting section and the second light emitting section such that there is a portion in which the region irradiated with light by the one light emitting section of the first light emitting section overlaps the region irradiated with light by the other light emitting section of the second light emitting section,
wherein, in the optical system, a diffusion degree of the light emitted from each of the light emitting sections in the first direction is larger than a diffusion degree of the light in the second direction.

10. The light emitting device according to claim 7, further comprising:

an optical system that guides light emitted from each of the first light emitting section and the second light emitting section such that there is a portion in which the region irradiated with light by the one light emitting section of the first light emitting section overlaps the region irradiated with light by the other light emitting section of the second light emitting section,
wherein the optical system does not optically act in the second direction, but optically acts in the first direction.

11. A measurement apparatus comprising:

the light emitting device according to any one of claims 1 to 10; and
an acquisition unit that receives reflected light from a measurement target irradiated with light emitted from the light emitting device, and acquires information regarding the measurement target.

12. A light emitting device comprising:

a substrate;

a light emitting unit that is provided on the substrate and has a plurality of light emitting sections, in which the plurality of light emitting sections are two-dimensionally arranged by being arranged in a first direction and a second direction intersecting the first direction, and the number of the light emitting sections arranged in the first direction is larger than the number of the light emitting sections arranged in the second direction; and

an optical system that guides light emitted from the light emitting section, wherein, in the optical system, a diffusion degree of the light emitted from each of the light emitting sections in the first direction is larger than a diffusion degree of the light emitted in the second direction.

**13.** A light emitting device comprising:

a substrate;

a light emitting unit that is provided on the substrate and has a plurality of light emitting sections, in which the plurality of light emitting sections are two-dimensionally arranged by being arranged in a first direction and a second direction intersecting the first direction, and the number of the light emitting sections arranged in the first direction is larger than the number of the light emitting sections arranged in the second direction; and

an optical system that guides light emitted from the light emitting section,

wherein the optical system does not optically act in the second direction, but optically acts in the first direction.

**14.** A light emitting device comprising:

a substrate;

a light emitting unit that is provided on the substrate and has a plurality of light emitting sections, in which the plurality of light emitting sections are two-dimensionally arranged by being arranged in a first direction and a second direction intersecting the first direction, and the number of the light emitting sections arranged in the first direction is larger than the number of the light emitting sections arranged in the second direction; and

an optical system that guides light emitted from the light emitting section,

wherein the optical system acts such that a region irradiated with light from one light emitting section among the plurality of light emitting sections overlaps a region irradiated with light from another light emitting section arranged in the second direction with respect to the one light emitting section.

# FIG. 1

EP 4 592 704 A1

# FIG. 2

# FIG. 3

FIG. 4A

EP 4 592 704 A1

FIG. 4B

EP 4 592 704 A1

EP 4 592 704 A1

# FIG. 5

FIG. 6

EP 4 592 704 A1

## FIG. 7

FIG. 8

EP 4 592 704 A1

# FIG. 9

# FIG. 10

# FIG. 11

Europäisches
Patentamt

European
Patent Office

Office européen
des brevets

## EUROPEAN SEARCH REPORT

**Application Number**

EP 24 18 8787

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 246 177 A1 (SONY SEMICONDUCTOR SOLUTIONS CORP [JP]) 20 September 2023 (2023-09-20) * paragraph [0038]; figures 6-8,19 * * paragraph [0066] * * figures 28-32 * * paragraph [0113] - paragraph [0117] * | 1-5,11 | INV. G01S7/481 H01S5/042 H01S5/42 |
| X | US 2021/234342 A1 (DONOVAN MARK J [US]) 29 July 2021 (2021-07-29) * figures 2b,3 * * paragraph [0002] - paragraph [0003]; figure 4 * | 1-5,11 | |
| X | WO 2023/283489 A1 (LUMILEDS LLC [US]) 12 January 2023 (2023-01-12) | 1 | |
| A | * paragraph [0003]; figures 1-3 * | 2-5,11 | |

**TECHNICAL FIELDS SEARCHED (IPC)**

G01S
H01S
F21S

~~The present search report has been drawn up for all claims~~

| Place of search | Date of completion of the search | Examiner |
|---|---|---|
| Munich | 20 December 2024 | Cortona, Anna |

EPO FORM 1503 03.82 (P04C01)

Europäisches
Patentamt

European
Patent Office

Office européen
des brevets

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-5, 11

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

The Search Division considers that the present European patent application does not comply with the requirements of unity of invention and relates to several inventions or groups of inventions, namely:

1. claims: 1-5, 11

    Light emitting device with a substrate; a light emitting unit with a plurality of light emitting sections; a first switching unit on the substrate, switching a first light emitting section between a light emitting and a non-light emitting state; and a second switching unit on the substrate, on an opposite side of the first switching unit, with the light emitting unit interposed there between, switching a second light emitting section. Dependent claims 2 - 5 define a wiring, a power supply terminal and that the electrical resistances between the first switching unit and the first light emitting section and that between the second switching unit and the second light emitting section are larger than an electrical resistance of the wiring.
    - - -

2. claims: 6-11

    Dependent claim 6 further defines that - in the device of claim 1 - the plurality of light emitting sections are arranged two-dimensionally along a first direction and a second, intersecting, direction, and the number of the light emitting sections arranged in the first direction is larger than those arranged in the second direction. Dependent claims 7 - 10 define a region irradiated with light by one light emitting section in the first light emitting section that overlaps a region irradiated with light by another light emitting section that is arranged in the second direction with respect to the one light emitting section in the second light emitting section, andthe first switching unit and the second switching unit select any of the one light emitting section or the other light emitting section and switch the selected light emitting section to the light emitting state.
    - - -

3. claim: 12

    Light emitting device with a substrate; a light emitting unit with a plurality of light emitting sections two-dimensionally arranged in a first direction and a second, intersecting direction, wherein the number of the light emitting sections in the first direction is larger than the number of the light emitting sections in the second direction; an optical system guiding light emitted from the light emitting section, wherein a diffusion degree of the light emitted from each of the light emitting sections in the first direction is larger than a diffusion degree of the light emitted in the second direction.
    - - -

Europäisches
Patentamt

European
Patent Office

Office européen
des brevets

**LACK OF UNITY OF INVENTION
SHEET B**

The Search Division considers that the present European patent application does not comply with the requirements of unity of invention and relates to several inventions or groups of inventions, namely:

4. claim: 13

Light emitting device with a substrate; a light emitting unit with a plurality of light emitting sections two-dimensionally arranged in a first direction and a second, intersecting direction, wherein the number of the light emitting sections in the first direction is larger than the number of the light emitting sections in the second direction; an optical system guiding light emitted from the light emitting section, wherein the optical system does not optically act in the second direction, but optically acts in the first direction.

- - -

5. claim: 14

Light emitting device with a substrate; a light emitting unit with a plurality of light emitting sections two-dimensionally arranged in a first direction and a second, intersecting direction, wherein the number of the light emitting sections in the first direction is larger than the number of the light emitting sections in the second direction; an optical system guiding light emitted from the light emitting section and acting such that a region irradiated with light from one light emitting section of the first plurality overlaps a region irradiated with light from another light emitting section arranged in the second direction with respect to the one light emitting section.

- - -

## ANNEX TO THE EUROPEAN SEARCH REPORT
## ON EUROPEAN PATENT APPLICATION NO.

EP 24 18 8787

This annex lists the patent family members relating to the patent documents cited in the above-mentioned European search report.
The members are as contained in the European Patent Office EDP file on
The European Patent Office is in no way liable for these particulars which are merely given for the purpose of information.

20-12-2024

| Patent document cited in search report | | Publication date | Patent family member(s) | | Publication date |
|---|---|---|---|---|---|
| EP 4246177 | A1 | 20-09-2023 | EP | 4246177 A1 | 20-09-2023 |
| | | | JP | 2023182875 A | 27-12-2023 |
| | | | US | 2024019547 A1 | 18-01-2024 |
| | | | WO | 2022102447 A1 | 19-05-2022 |
| US 2021234342 | A1 | 29-07-2021 | CN | 115004053 A | 02-09-2022 |
| | | | EP | 4094093 A1 | 30-11-2022 |
| | | | JP | 2023511371 A | 17-03-2023 |
| | | | KR | 20220124192 A | 13-09-2022 |
| | | | US | 2021234342 A1 | 29-07-2021 |
| | | | WO | 2021150860 A1 | 29-07-2021 |
| WO 2023283489 | A1 | 12-01-2023 | CN | 117616569 A | 27-02-2024 |
| | | | EP | 4367719 A1 | 15-05-2024 |
| | | | JP | 2024527350 A | 24-07-2024 |
| | | | KR | 20240023103 A | 20-02-2024 |
| | | | US | 2023020077 A1 | 19-01-2023 |
| | | | WO | 2023283489 A1 | 12-01-2023 |

EPO FORM P0459

For more details about this annex : see Official Journal of the European Patent Office, No. 12/82

**REFERENCES CITED IN THE DESCRIPTION**

**Patent documents cited in the description**

• JP 2023042123 A